# EUROPEAN PATENT APPLICATION

(11) **EP 1 445 803 A2**
(43) Date of publication of application: **11.08.2004**
(21) Application number: 04002584.3
(22) Date of filing: 05.02.2004
(51) Int. Cl.: H01L 31/0203

(54) **Solid state imaging device with sealing window smaller than the imager chip**

(30) Priority: 06.02.2003 JP 2003029093; 28.02.2003 JP 2003053165
(71) Applicant: Sharp Kabushiki Kaisha, Osaka-shi, Osaka 545-8522 (JP)
(72) Inventor: Fujita, Kazuya, Mie 518-0475 (JP); Tsukamoto, Hiroaki, Nara 635-0045 (JP); Yasudome, Takashi, Nara 633-0007 (JP)
(74) Representative: Müller - Hoffmann & Partner

(57) **Abstract**

With the reduced size of a solid state imaging device, the invention provides: a solid state imaging device of a chip size and having good environmental durability; a semiconductor wafer used for fabricating a solid state imaging device; an optical device module incorporating a solid state imaging device; a method of solid state imaging device fabrication; and a method of optical device module fabrication. The solid state imaging device comprises: a solid state image pickup device formed on a semiconductor substrate; a light-transparent cover arranged opposite to an effective pixel region, so as to protect (the surface of) the effective pixel region formed in one surface of the solid state image pickup device against external environment; and an adhering section formed outside the effective pixel region in the one surface of the solid state image pickup device, so as to adhere the light-transparent cover and the solid state image pickup device.

## Description

### BACKGROUND OF THE INVENTION

The present invention relates to a solid state imaging device used in imaging in a portable phone or the like, a semiconductor wafer used in the fabrication of a solid state imaging device, an optical device module using a solid state imaging device, a method of solid state imaging device fabrication, and a method of optical device module fabrication.

### DESCRIPTION OF THE RELATED ART

In an area sensor or a linear sensor using a solid state image pickup device such as a CCD, the solid state image pickup device is contained and sealed in a hollow package formed of ceramic or plastic, so that moisture and dust in the outside are prevented from entering the package. Examples of solid state imaging devices including such an area sensor and a linear sensor using a hollow package are disclosed in Japanese Patent Application Laid-Open No. H06-021414. Further, Japanese Patent Application Laid-Open No. 2002-512436 discloses a technique of integrated circuit device fabrication in which a radiation-transparent insulating substrate composed of glass or the like is adhered to the active surface of a silicon wafer, and in which the silicon wafer is then diced, and so is the radiation-transparent insulating substrate, so that individual integrated circuit devices are formed.

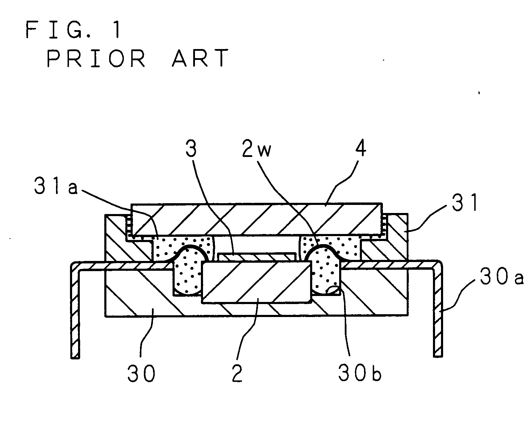

FIG. 1 is a cross sectional view showing a schematic configuration of a prior art solid state imaging device. Such a solid state imaging device is described in Japanese Patent Application Laid-Open No. H06-021414. In the solid state imaging device 1, a hollow package is formed that comprises a space between a recess 30b which is provided approximately in the center of a base 30 and a light-transparent cover 4 which is attached to the base 30 with a frame 31 therebetween. Then, a solid state image pickup device 2 is arranged in this space. The solid state image pickup device 2 is placed in the recess 30b provided approximately in the center of the base 30 composed of ceramic, plastic, or the like, while leads 30a extending outward from the periphery of the base 30 are attached to the base 30. The leads 30a composed of 42-alloy, copper, or the like are electrically connected through bonding wires 2w to the solid state image pickup device 2.

A frame 31 having a predetermined height is attached on top of the leads 30a, while the light-transparent cover 4 composed of glass or the like is embedded in a cut-off section of the frame 31. A sealant 31a composed of epoxy resin is used in the adhesion between the frame 31 and the light-transparent cover 4, so as to seal the space formed between the light-transparent cover 4 and the recess 30b. This structure which seals the space formed between the light-transparent cover 4 and the recess 30b prevents moisture and dust in the outside from entering the space around the solid state image pickup device 2. At that time, the sealant 31a fills the space over the outside of the effective pixel region 3 of the solid state image pickup device 2.

The method of fabrication of the solid state imaging device 1 is as follows. The solid state image pickup device 2 is mounted in the recess 30b of the base 30. Then, the solid state image pickup device 2 is connected to the leads 30a with the bonding wires 2w. Then, the frame 31 having a predetermined height is attached on top of the leads 30a. Further, the light-transparent cover 4 composed of glass or the like is adhered to the cut-off section of the frame 31 with the sealant 31a. At that time, the sealant 31a is applied such as to fill the space over a predetermined region outside the effective pixel region 3 of the solid state image pickup device 2. Then, the sealant 31a is cured completely so as to form a sealing structure in the region outside the effective pixel region 3 of the solid state image pickup device 2 in a state surrounding the bonding wires 2w, so as to seal the space formed between the light-transparent cover 4 and the recess 30b.

The solid state imaging device 1 fabricated as such acquires light from the outside via the light-transparent cover 4, so that the effective pixel region 3 of the solid state image pickup device 2 receives the light. The light received in the effective pixel region 3 is converted into a predetermined electric signal by the solid state image pickup device 2, so that the electric signal is outputted through the bonding wires 2w and the leads 30a.

In camera-equipped portable phones and digital still cameras, with the progress of size reduction of the products, requirement is increasing for the size reduction of the camera modules. Nevertheless, in the prior art solid state imaging device 1, the light-transparent cover 4 for protecting the effective pixel region 3 of the solid state image pickup device 2 against dust and damage has larger planar dimensions (size) than the solid state image pickup device 2 itself. That is, the above-mentioned structure that the light-transparent cover 4 covers not only the effective pixel region 3 alone but also the entirety, or even also the outer region, of the solid state image pickup device 2 is disadvantageous in the size reduction. Thus, in the packaging of the solid state image pickup device 2, the largeness of the area of the solid state imaging device 1 has restricted the size reduction of the solid state imaging device 1.

Further, in the prior art method of fabrication of the solid state imaging device 1, a plurality of the solid state image pickup devices 2 formed simultaneously on a semiconductor wafer are divided into individual pieces using a dicing saw or the like. Then, the divided solid state image pickup device 2 is mounted in a package or on a substrate, and then a light-transparent cover 4 is attached so as to cover the entirety, or even also the outer region, of the solid state image pickup device 2. Thus, between the process carried out in a semiconductor wafer state and the process of attaching the light-transparent cover 4, the process is carried out that divides the solid state image pickup devices 2 on the semiconductor wafer into individual pieces using a dicing saw or the like. In this process of dividing into individual pieces (a dicing process), shavings easily attach as dust particles to the effective pixel regions 3 of the solid state image pickup devices 2 on the semiconductor wafer. This causes a possibility of resulting damage to the surface of the effective pixel regions 3 of the solid state image pickup devices 2. Further, in the process of mounting the solid state image pickup device 2 into the recess 30b of the base 30 using a vacuum chuck handler, there is another possibility of causing damage to the surface of the effective pixel regions 3 of the solid state image pickup devices 2.

That is, these possibilities of damage to the surface of the effective pixel region 3 of the solid state image pickup device 2 result from the fact that the light-transparent cover 4 is attached after the solid state image pickup device 2 has been divided into an individual piece. In the prior art, in order to avoid such damage to the surface of the effective pixel region 3 of the solid state image pickup device 2, the fabrication processes until the attachment of the light-transparent cover 4 after the dividing of the solid state image pickup device 2 into an individual piece need to be carried out in a cleaner room. Further, its assembling process needs much care and attention in order to avoid damage to the surface of the effective pixel regions 3 of the solid state image pickup devices 2. Such situation has narrowed the allowable range of fabrication conditions, and hence resulted in a limit in the reduction of the fraction defective in the processes after the dividing of the solid state image pickup device 2 into an individual piece.

As described above, in the prior art solid state imaging device, the light-transparent cover has larger planar dimensions than the solid state image pickup device itself. This has caused the problem that this largeness restricts the size reduction of the solid state imaging device. Further, in the prior art method of fabrication of the solid state imaging device, the light-transparent cover is attached after the solid state image pickup device has been divided into an individual piece. This has caused the problem that the reduction or avoidance of the occurrence of damage to the surface of the effective pixel region of the solid state image pickup device is notably difficult, and that the reduction of the fraction defective is limited.

### SUMMARY OF THE INVENTION

The invention has been devised with considering such problems. An object of the invention is to provide a solid state imaging device in which a light-transparent cover having planar dimensions smaller than those of a solid state image pickup device is adhered opposite to the effective pixel region in one surface of the solid state image pickup device, so as to protect the effective pixel region such as to prevent external influences (such as moisture and dust) from affecting the surface of the effective pixel region, and in which at the same time, the size of the solid state imaging device is reduced so that a solid state imaging device of a chip size having high reliability and high environmental durability is realized.

Another object of the invention is to provide a semiconductor wafer on which a plurality of solid state image pickup devices are formed, in which a light-transparent plate or a light-transparent cover for protecting the surface of the effective pixel region of solid state image pickup device is formed before the dividing of the solid state image pickup devices into individual pieces, so as to permit easy storage and carriage and avoid the attachment of dust or the occurrence of damage to the surface of the effective pixel region after the process of dividing the solid state image pickup devices into individual pieces, so that the fraction defective is reduced in the process of assembling the solid state image pickup device especially after the dividing into individual pieces.

Another object of the invention is to provide an optical device module such as a camera module permitting easy size reduction and having good portability by means of incorporating a solid state imaging device according to the invention.

Another object of the invention is to provide a method of solid state imaging device fabrication, in which a light-transparent cover is adhered opposite to each effective pixel region so as to protect the effective pixel region of each of solid state image pickup devices formed on a semiconductor wafer, so that defects such as the attachment of dust and the occurrence of damage to the surface of the effective pixel region are avoided especially in the process of dividing of the solid state image pickup devices into individual pieces.

Another object of the invention is to provide a method of solid state imaging device fabrication, in which a light-transparent plate is adhered opposite to the effective pixel regions so as to protect the effective pixel regions of solid state image pickup devices formed on a semiconductor wafer, and in which the light-transparent plate is then divided and thereby forms light-transparent covers, so as to avoid defects such as the attachment of dust and the occurrence of damage to the surface of the effective pixel region, so that the process of adhering the light-transparent covers to a plurality of solid state image pickup devices is achieved on a semiconductor wafer basis, and that high efficiency and productivity are obtained.

Another object of the invention is to provide an optical device module and a method of its fabrication, in which an optical device module is fabricated with incorporating a solid state imaging device (solid state image pickup device) the effective pixel region of which is protected by a light-transparent cover, so as to permit size reduction (thickness reduction and weight reduction), yield improvement, process simplification, and price reduction.

Another object of the invention is to provide an optical device module and a method of its fabrication, in which an optical device module is fabricated with incorporating a solid state imaging module component formed by integrating and resin-sealing a DSP (digital signal processor serving as an image processor) and a solid state imaging device (solid state image pickup device), so as to permit size reduction (thickness reduction and weight reduction), yield improvement, process simplification, and price reduction, as well as higher environmental durability (such as against moisture) and mechanical strength.

Another object of the invention is to provide an optical device module and a method of its fabrication, in which a DSP (serving as an image processor) and a solid state imaging device (solid state image pickup device) are integrated onto a wiring board, and in which a sealing section for resin-sealing them is formed. This permits size reduction (thickness reduction and weight reduction), yield improvement, process simplification, and price reduction, as well as higher environmental durability (such as against moisture), higher mechanical strength, and further process simplification.

A solid state imaging device according to the invention comprises: a solid state image pickup device having an effective pixel region in one surface thereof, a light-transparent cover arranged opposite to said effective pixel region and having planar dimensions smaller than those of said solid state image pickup device; and an adhering section for adhering said solid state image pickup device and said light-transparent cover.

In a solid state imaging device according to the invention, said adhering section contains photosensitive adhesive.

In a solid state imaging device according the invention, a space is formed between said effective pixel region and said light-transparent cover, while said adhering section is formed outside said effective pixel region in said one surface of said solid state image pickup device.

In a solid state imaging device according to the invention, said adhering section seals the outer periphery of said space.

A semiconductor wafer according to the invention on which a plurality of solid state image pickup devices each having an effective pixel region in one surface thereof are formed comprises: a light-transparent plate arranged opposite to said effective pixel region; and an adhering section for adhering said solid state image pickup device and said light-transparent plate.

In a semiconductor wafer according to the invention, said light-transparent plate is divided so as to form light-transparent covers each having planar dimensions smaller than those of said solid state image pickup device.

A semiconductor wafer according to the invention on which a plurality of solid state image pickup devices each having an effective pixel region in one surface thereof are formed comprises: a light-transparent cover arranged opposite to said effective pixel region; and an adhering section for adhering said solid state image pickup device and said light-transparent cover.

In a semiconductor wafer according to the invention, said adhering section contains photosensitive adhesive.

In a semiconductor wafer according to the invention, a space is formed between said effective pixel region and said light-transparent cover, while said adhering section is formed outside said effective pixel region in said one surface of said solid state image pickup device.

In a semiconductor wafer according to the invention, said adhering section seals the outer periphery of said space.

An optical device module according to the invention comprises: a lens; a lens retainer for retaining said lens; and a solid state imaging device according to any specific one of the present invention, wherein said light-transparent cover is arranged opposite to said lens and inside said lens retainer.

A method of solid state imaging device fabrication according to the invention comprises the steps of forming a plurality of solid state image pickup devices each having an effective pixel region in one surface thereof, onto a semiconductor wafer; adhering a light-transparent cover having planar dimensions smaller than those of said solid state image pickup device, in a manner opposite to said effective pixel region onto said one surface; and dividing a plurality of said solid state image pickup devices onto each of which said light-transparent cover has been adhered, into individual solid state image pickup devices.

A method of solid state imaging device fabrication according to the invention further comprises the step of dividing a light-transparent plate so as to form said light-transparent covers.

In a method of solid state imaging device fabrication according to the invention, in said step of adhering, adhesive is used that is patterned in a region outside said effective pixel region in said one surface of said solid state image pickup device.

In a method of solid state imaging device fabrication according to the invention, in said step of adhering, adhesive is used that is patterned on said light-transparent plate in correspondence to a region outside said effective pixel region in said one surface of said solid state image pickup device.

In a method of solid state imaging device fabrication according to the invention, the adhesive-patterned surface of said light-transparent plate is affixed onto a dicing tape, and then said light-transparent plate is divided so as to form said light-transparent covers.

In a method of solid state imaging device fabrication according to the invention, said adhesive contains photosensitive adhesive.

A method of solid state imaging device fabrication according to the invention comprises the steps of forming a plurality of solid state image pickup devices each having an effective pixel region in one surface thereof, onto a semiconductor wafer; adhering a light-transparent plate onto said one surface of said semiconductor wafer; dividing said light-transparent plate having been adhered onto said semiconductor wafer, so as to form light-transparent covers each being opposite to said effective pixel region; and dividing a plurality of said solid state image pickup devices into individual solid state image pickup devices.

In a method of solid state imaging device fabrication according to the invention, in said step of adhering, adhesive is used that is patterned in a region outside said effective pixel region in said one surface of said solid state image pickup device.

In a method of solid state imaging device fabrication according to the invention, in said step of adhering, adhesive is used that is patterned on said light-transparent plate in correspondence to a region outside said effective pixel region in said one surface of said solid state image pickup device.

In a method of solid state imaging device fabrication according to the invention, said adhesive contains photosensitive adhesive.

An optical device module according to the invention comprises: a wiring board on which wiring is formed; an image processor adhered to said wiring board and electrically connected to said wiring; a solid state imaging device in which a light-transparent cover having planar dimensions smaller than those of a solid state image pickup device is attached opposite to the effective pixel region of said solid state image pickup device, and which is adhered to said image processor and electrically connected to said wiring; and an optical path defining unit arranged opposite to said solid state imaging device and denning an optical path to said solid state imaging device.

An optical device module according to the invention comprises: a solid state imaging module component formed by resin-sealing: a module component wiring board on which wiring is formed; an image processor adhered to said module component wiring board and electrically connected to said wiring; and a solid state imaging device in which a light-transparent cover having planar dimensions smaller than those of a solid state image pickup device is attached opposite to the effective pixel region of said solid state image pickup device, and which is adhered to said image processor and electrically connected to said wiring; in the state that the surface of said light-transparent cover is exposed; and an optical path defining unit arranged opposite to said solid state imaging device and defining an optical path to said solid state imaging device.

In an optical device module according to the invention, an external terminal connected to said wiring is formed on the surface of said module component wiring board reverse to the surface to which said image processor is adhered.

In an optical device module according to the invention, said external terminal has a protruding shape.

In an optical device module according to the invention, said optical device module further comprises a wiring board on which wiring is formed, while said external terminal of said module component wiring board is connected to said wiring of said wiring board.

An optical device module according to the invention comprises: a wiring board on which wiring is formed; an image processor adhered to said wiring board and electrically connected to said wiring; a solid state imaging device in which a light-transparent cover having planar dimensions smaller than those of a solid state image pickup device is attached opposite to the effective pixel region of said solid state image pickup device, and which is adhered to said image processor and electrically connected to said wiring; a sealing section for resin-sealing said wiring board, said image processor, and said solid state imaging device in the state that the surface of said light-transparent cover is exposed; and an optical path defining unit arranged opposite to said solid state imaging device and defining an optical path to said solid state imaging device.

In an optical device module according to the invention, said optical path defining unit retains a lens arranged opposite to said light-transparent cover of said solid state imaging device.

A method of optical device module fabrication according to the invention comprises the steps of: adhering an image processor to a wiring board on which wiring is formed, and then connecting the connection terminals of said image processor to said wiring; adhering a solid state imaging device in which a light-transparent cover having planar dimensions smaller than those of a solid state image pickup device is attached opposite to the effective pixel region of said solid state image pickup device, to said image processor, and then connecting the connection terminals of said solid state imaging device to said wiring; and aligning said solid state imaging device and an optical path defining unit for defining an optical path to said solid state imaging device.

In a method of optical device module fabrication according to the invention, a plurality of optical device modules are formed simultaneously on a multiple wiring board formed by linking a plurality of said wiring boards, while said multiple wiring board is then divided so that a plurality of said optical device modules are divided into individual optical device modules.

A method of optical device module fabrication according to the invention comprises the steps of adhering an image processor to a module component wiring board on which wiring is formed, and then connecting the connection terminals of said image processor to said wiring; adhering a solid state imaging device in which a light-transparent cover having planar dimensions smaller than those of a solid state image pickup device is attached opposite to the effective pixel region of said solid state image pickup device, to said image processor, and then connecting the connection terminals of said solid state imaging device to said wiring; resin-sealing said module component wiring board, said image processor, and said solid state imaging device in the state that the surface of said light-transparent cover is exposed, and thereby forming a solid state imaging module component; and aligning said solid state imaging device and an optical path defining unit for defining an optical path to said solid state imaging device.

In a method of optical device module fabrication according to the invention, an external terminal is formed on the surface of said module component wiring board reverse to the surface to which said image processor is adhered, while said method further comprises the step of connecting said external terminal to said wiring formed on said wiring board.

In a method of optical device module fabrication according to the invention, said external terminal has a protruding shape.

In a method of optical device module fabrication according to the invention, a plurality of solid state imaging module components are formed simultaneously on a multiple module component wiring board formed by linking a plurality of said module component wiring boards, while said multiple module component wiring board is then divided so that a plurality of said solid state imaging module components are divided into individual solid state imaging module components.

In a method of optical device module fabrication according to the invention, a plurality of optical device modules are formed simultaneously on a multiple wiring board formed by linking a plurality of said wiring boards, while said multiple wiring board is then divided so that a plurality of said optical device modules are divided into individual optical device modules.

A method of optical device module fabrication according to the invention comprises the steps of adhering an image processor to a wiring board on which wiring is formed, and then connecting the connection terminals of said image processor to said wiring; adhering a solid state imaging device in which a light-transparent cover having planar dimensions smaller than those of a solid state image pickup device is attached opposite to the effective pixel region of said solid state image pickup device, to said image processor, and then connecting the connection terminals of said solid state imaging device to said wiring; resin-sealing said wiring board, said image processor, and said solid state imaging device in the state that the surface of said light-transparent cover is exposed, and thereby forming a sealing section; and aligning said solid state imaging device and an optical path defining unit for defining an optical path to said solid state imaging device.

In a method of optical device module fabrication according to the invention, a plurality of optical device modules are formed simultaneously on a multiple wiring board formed by linking a plurality of said wiring boards, while said multiple wiring board is then divided so that a plurality of said optical device modules are divided into individual optical device modules.

According to the invention, the light-transparent cover for protecting the effective pixel region has planar dimensions smaller than those of the solid state image pickup device. This permits the size reduction of the solid state imaging device, and realizes a solid state imaging device of a chip size.

According to the invention, the adhering section contains photosensitive adhesive. This permits the use of a photolithography technique, so as to realize precise pattern formation (shape and position) of the adhering section, and further permit simultaneous multiple formation.

According the invention, a space is formed over the surface of the effective pixel region. This prevents physical stress from acting on the effective pixel region. Further, the adhering section is formed outside the effective pixel region, and hence no optical material is arranged between the light-transparent cover and the effective pixel region. This avoids a reduction in the light transparency between the light-transparent cover and the effective pixel region.

According to the invention, the adhering section seals the outer periphery of the space formed between the light-transparent cover and the effective pixel region. This prevents moisture and dust in the outside from entering the effective pixel region, and hence securely protects the effective pixel region, so as to permit a reliable and environment-durable solid state imaging device.

According to the invention, a light-transparent plate, a light-transparent cover, or a light-transparent cover formed by dividing a light-transparent plate each for protecting the surface of the effective pixel region of the solid state image pickup device is formed before a plurality of the solid state image pickup devices formed on a semiconductor wafer are divided into individual pieces. This avoids the attachment of dust and the occurrence of a scratch in the surface of the effective pixel region after the process of dividing into individual pieces, so as to permit easy and safe storage and carriage in a semiconductor wafer state.

According to the invention, an optical device module is fabricated with incorporating a solid state imaging device according to the invention. This permits a small optical device module having good portability.

According to the invention, the light-transparent cover is adhered or formed to each solid state image pickup device in a semiconductor wafer state. This avoids the attachment of dust and the occurrence of a scratch in the surface of the effective pixel region after the process of deviding the solid state image picking device into individual pieces the fraction defective in the fabrication process of the solid state imaging device. Further, since the light-transparent cover is adhered individually to each solid state image pickup device, the adhesion of the light-transparent cover can be omitted for solid state image pickup devices having been determined as defective in advance. This improves the productivity.

According to the invention, adhesive formed in a pattern on the solid state image pickup device on a semiconductor wafer, or alternatively on the light-transparent plate, is used so as to adhere the light-transparent cover (light-transparent plate) for protecting the effective pixel region. This permits simultaneous pattern formation of the adhesive in a plurality of the solid state image pickup devices or in a plurality of the light-transparent covers, and hence improves the productivity. Further, in the dividing of the adhesive-patterned light-transparent plate on which the adhesive is patterned, the light-transparent plate is divided in the state that the adhesive-patterned surface is affixed to a dicing tape. This permits the formation of the light-transparent covers with reducing the production of dust.

According to the invention, after the semiconductor wafer on which a plurality of solid state image pickup devices are formed is adhered to the light-transparent plate, the light-transparent plate is divided so as to form the light-transparent cover for each solid state image pickup device. This achieves simultaneous adhesion of the light-transparent covers to a plurality of solid state image pickup devices. That is, this simplifies the alignment of the light-transparent cover in comparison with the case that the light-transparent cover is adhered individually to each solid state image pickup device, so as to simplify the process and improve the productivity. In particular, when the adhering section is formed on the semiconductor wafer so that the light-transparent plate is adhered, the alignment of the light-transparent plate is notably easy so that the light-transparent covers are formed efficiently.

According to the invention, the solid state imaging device in which the light-transparent cover having planar dimensions smaller than those of the solid state image pickup device is attached (adhered by the adhering section) opposite to the effective pixel region of the solid state image pickup device is built into an optical device module. This permits the size reduction (thickness reduction and weight reduction) of the optical device module. Since the solid state imaging device (solid state image pickup device) the effective pixel region of which is protected by the light-transparent cover is assembled into the optical device module, the attachment of dust is avoided to the surface of the effective pixel region of the solid state imaging device (solid state image pickup device) in the processes after the assembling of the solid state imaging device. This permits the fabrication even in a production environment of low cleanness.

This realizes an optical device module and a method of its fabrication that permit yield improvement, process simplification, and price reduction. Further, a multiple wiring board formed by linking a plurality of wiring boards is used. This permits simultaneous fabrication of a plurality of optical device modules, and hence improves further the production efficiency of the optical device module. Further, this achieves uniformity in the characteristics of the optical device modules.

According to the invention, a solid state imaging module component formed by integrating and resin-sealing a DSP (serving as an image processor) and a solid state imaging device (solid state image pickup device) is used, so as to realize an optical device module having higher environmental durability (such as against moisture) and mechanical strength. Further, this permits the assembling process of the optical device module even in a production environment of lower cleanness. Since the solid state imaging module component comprises an external terminal capable of being connected to the outside by means of soldering or the like, this module component is easily assembled into another wiring board. This realizes an optical device module having high productivity.

According to the invention, a DSP (serving as an image processor) and a solid state imaging device (solid state image pickup device) are integrated onto a wiring board, so that a sealing section for resin-sealing them is formed. This simplifies further the fabrication process. Further, since the wiring board performs resin sealing, an optical device module is obtained that has higher environmental durability (such as against moisture) and mechanical strength. Further, this configuration allows a lens retainer to be attached to the sealing section. This permits a simpler shape of the lens retainer, and hence simplifies the assembling of the lens retainer.

The above and further objects and features of the invention will more fully be apparent from the following detailed description with accompanying drawings.

### BRIEF DESCRIPTION OF THE SEVERAL VIEWS OF THE DRAWINGS

FIG. 1 is a cross sectional view showing schematic configuration of a prior art solid state imaging device.
FIGS. 2A and 2B are diagrams illustrating schematic configuration of a solid state imaging device according to Embodiment 1 of the invention.
FIGS. 3A-3E are diagrams illustrating a method of solid state imaging device fabrication according to Embodiment 2 of the invention.
FIGS. 4A and 4B are diagrams illustrating a method of solid state imaging device fabrication according to Embodiment 2 of the invention.
FIGS. 5A and 5B are diagrams illustrating a method of solid state imaging device fabrication according to Embodiment 2 of the invention.
FIGS. 6A and 6B are diagrams illustrating a method of solid state imaging device fabrication according to Embodiment 3 of the invention.
FIGS. 7A-7C are diagrams illustrating a method of solid state imaging device fabrication according to Embodiment 3 of the invention.
FIGS. 8A and 8B are diagrams illustrating a method of solid state imaging device fabrication according to Embodiment 4 of the invention.
FIGS. 9A-9C are diagrams illustrating a method of solid state imaging device fabrication according to Embodiment 4 of the invention.
FIG. 10 is a cross sectional view showing schematic configuration of an optical device module according to Embodiment 5 of the invention.
FIG. 11 is a cross sectional view showing schematic configuration of an optical device module according to Embodiment 6 of the invention.
FIGS. 12-15 are process diagrams showing cross sectional views of the fabrication processes of an optical device module according to Embodiment 6 of the invention.
FIG. 16 is a cross sectional view showing schematic configuration of an optical device module according to Embodiment 7 of the invention.
FIGS. 17-24 are process diagrams showing cross sectional views of the fabrication processes of an optical device module according to Embodiment 7 of the invention.
FIG. 25 is a cross sectional view showing schematic configuration of an optical device module according to Embodiment 8 of the invention.
FIGS. 26 and 27 are process diagrams showing cross sectional views of the fabrication processes of an optical device module according to Embodiment 8 of the invention.

### DETAILED DESCRIPTION OF THE PREFERRED EMBODIMENTS

The invention is described below with reference to the drawings showing the embodiments.

### [Embodiment 1]

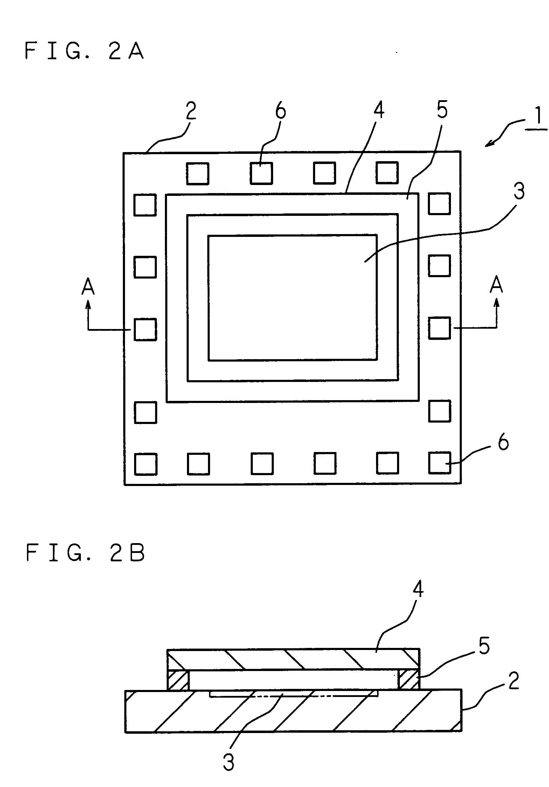

FIGS. 2A and 2B are diagrams illustrating schematic configuration of a solid state imaging device according to Embodiment 1 of the invention. FIG. 2A is a plan view of the solid state imaging device viewed in a plane (one plane or one surface). FIG. 2B is a cross sectional view along the arrow line A-A in FIG. 2A. Numeral 1 indicates the solid state imaging device comprising: a solid state image pickup device 2 formed in a plan-view shape of a rectangle on a semiconductor substrate; a light-transparent cover 4 arranged opposite to an effective pixel region 3 in order to protect (the surface of) the effective pixel region 3 formed in one surface of the solid state image pickup device 2 against moisture, dust (particles and shavings), and the like in the outside; and an adhering section 5 formed outside the effective pixel region 3 in one surface of the solid state image pickup device 2 so as to adhere the light-transparent cover 4 and the solid state image pickup device 2.

The solid state imaging device 1 acquires light from the outside via the light-transparent cover 4, so that the effective pixels (light-receiving elements) arranged in the effective pixel region 3 of the solid state image pickup device 2 receive the light. The light-transparent cover 4 is composed of a light-transparent material such as glass. The light-transparent cover 4 is arranged opposite to the effective pixel region 3 such as to cover at least the effective pixel region 3, and thereby protect the effective pixel region 3 against the outside. The light-transparent cover 4 has smaller planar dimensions (size) than the solid state image pickup device 2. This permits the size reduction of the solid state image pickup device 2.

When the region outside the effective pixel region 3 of the solid state image pickup device 2 is adhered to the light-transparent cover 4 by the adhering section 5, a space is preferably formed between the effective pixel region 3 and the light-transparent cover 4. The space formed between the effective pixel region 3 and the light-transparent cover 4 allows the light acquired from the outside via the light-transparent cover 4 to be incident directly on the effective pixel region 3. This avoids an optical loss along the optical path. Bonding pads 6 serving as terminals for connecting the solid state image pickup device 2 to an external circuit (not shown) are provided between the adhering section 5 (light-transparent cover 4) and the outer peripheral edges (chip edges) of the solid state image pickup device 2.

In the adhering section 5, the outer periphery of the space formed between the effective pixel region 3 and the light-transparent cover 4 arranged opposite to each other is preferably sealed completely by adhesive. The sealing of the outer periphery of the space formed between the effective pixel region 3 and the light-transparent cover 4 avoids the occurrence of defects in the effective pixel region 3 caused by the entering of moisture or the entering and adhering of dust into (the surface of) the effective pixel region 3 or by scratching the surface. This realizes a reliable solid state imaging device 1 at a high yield in the fabrication process.

When the solid state imaging device 1 is built into an optical device such as a camera and a video recorder camera, in addition to the protection of the surface of the effective pixel region 3 against dust and scratches, the light-transparent cover 4 need shut out infrared rays from the outside. In this case, an infrared cut-off film is easily formed on the surface of the light-transparent cover 4.

### [Embodiment 2]

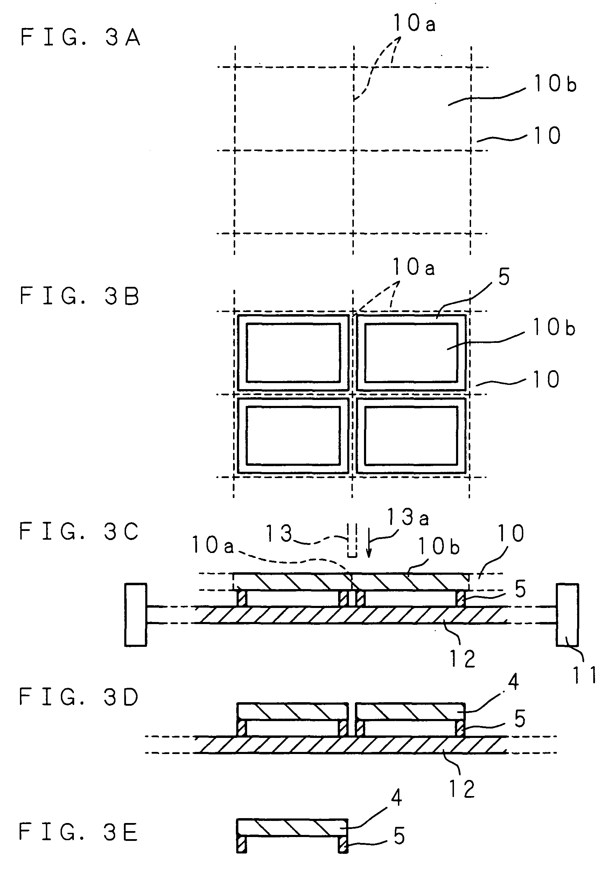

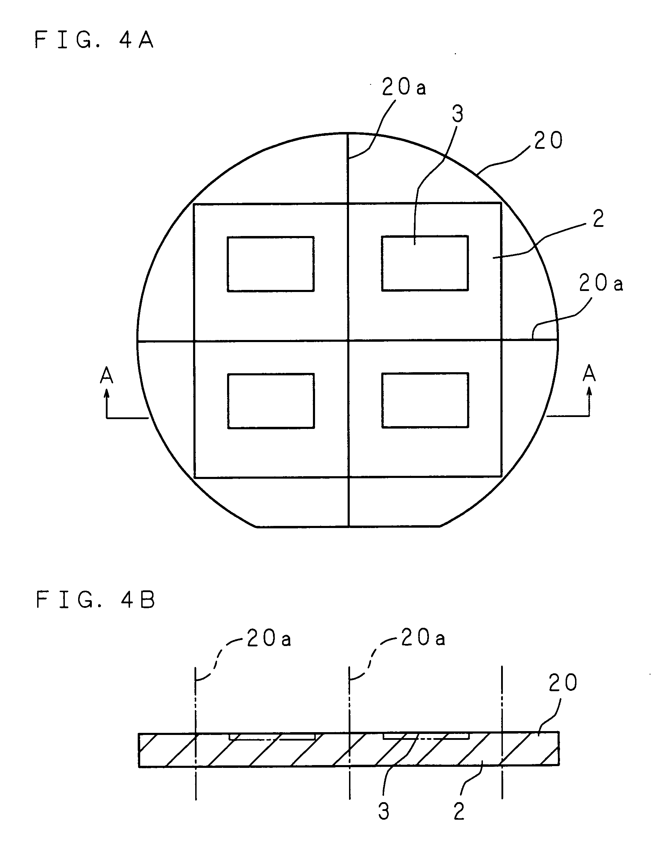

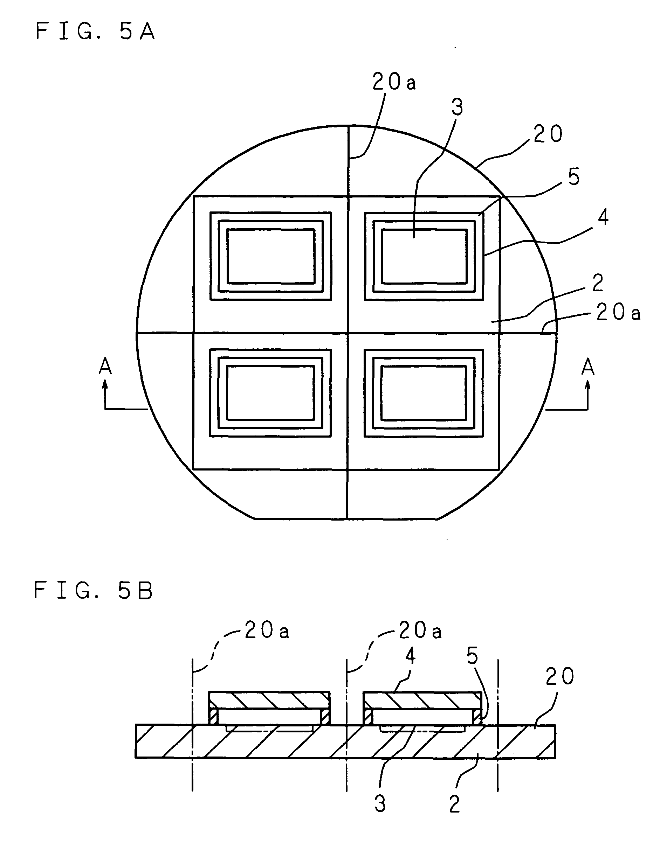

FIGS. 3A-5B are diagrams illustrating a method of solid state imaging device fabrication according to Embodiment 2 of the invention. More specifically, FIGS. 3A-3E are diagrams illustrating the process of formation of light-transparent covers. FIGS. 4A and 4B are diagrams illustrating the situation of solid state image pickup devices formed on a semiconductor wafer. FIGS. 5A and 5B are diagrams illustrating the situation that the light-transparent covers formed in FIGS. 3A-3E are adhered to one surface (that has the effective pixel regions) of the solid state image pickup devices of FIGS. 4A and 4B.

FIG. 3A shows a large-area light-transparent plate 10 composed of a glass plate or the like. The light-transparent plate 10 has a large area, and hence comprises a large number of cover corresponding regions 10b having boundaries indicated by dividing lines 10a. The area of the cover corresponding region 10b is adjusted appropriately such as to have the same planar dimensions as the light-transparent cover 4 when divided in a later process. FIG. 3B shows the situation that a large number of adhering sections 5 are formed simultaneously on the light-transparent plate 10. In one surface of the effective pixel region 3 of the solid state image pickup device 2, the adhering section 5 is patterned into an appropriate patterning shape correspondingly between the effective pixel region 3 and the bonding pads 6 serving as connection terminals to the outside.

When, adhesive in which photosensitive adhesive (such as a UV-setting resin belonging to the acrylic resin family) and thermosetting resin (such as an epoxy resin) are mixed is uniformly applied onto the light-transparent plate 10, and when pattern formation (patterning) is then carried out by means of a known photolithography technique, a large number of the adhering sections 5 are formed simultaneously on the light-transparent plate 10. This simultaneous formation of a large number of the adhering sections 5 on the light-transparent plate 10 improves the productivity. The purpose that the photosensitive adhesive is mixed into the thermosetting resin is to impart photosensitivity to the adhesive. This permits easy and precise patterning of the adhering sections 5 by means of the processing of the exposure and the development in the photolithography technique. The patterning of the adhering sections 5 can be carried out with precision. This permits precise formation of the adhering sections 5 even when the region outside the effective pixel region 3 is narrow.

Other patterning methods for the adhering sections 5 include: the patterning of the adhesive (such as an epoxy resin) by means of a printing method; and the patterning of the adhesive by means of a dispenser method. The patterning method used for the adhering sections 5 may be any one selected appropriately depending on the necessity or suitability for the light-transparent plate 10, the solid state imaging device 1, and the adhesive.

FIGS. 3C and 3D show the state that the light-transparent plate 10 on which a large number of the adhering sections 5 are patterned is diced along the dividing lines 10a, so that the cover corresponding regions 10b are divided into individual pieces so as to form light-transparent covers 4. That is, the surface of the light-transparent plate 10 on which the adhering sections 5 are formed is affixed to a dicing tape 12 fixed to a dicing ring 11. Then, a dicing saw 13 travels in the dicing direction 13a so as to divide the light-transparent plate 10 into the individual light-transparent covers 4. FIG. 3E shows the state that the light-transparent cover 4 on which the adhering section 5 is formed is removed from the dicing tape 12 under an appropriate condition.

In the dicing of the light-transparent plate 10, the adhering sections 5 formed on the light-transparent plate 10 are affixed to the dicing tape 12. This permits the formation of a hollow portion between the surface of the light-transparent plate 10 on which the adhering section 5 is formed and the dicing tape 12. This hollow portion serves as a space formed between the light-transparent cover 4 and the dicing tape 12, and thereby prevents the light-transparent cover 4 from contacting directly with the dicing tape 12 so as to prevent the light-transparent cover 4 from being contaminated with the dicing tape 12.

The outer periphery of the hollow portion is surrounded and sealed by the adhering section 5 and the dicing tape 12. This prevents dust (such as shavings) generated in the dicing of the light-transparent plate 10 from attaching to the inner surface (the surface on which the adhering section 5 is formed) of the light-transparent cover 4. That is, it is avoided that when the light-transparent cover 4 is attached opposite to the surface of the effective pixel region 3 of the solid state image pickup device 2, the dust having been attached to the inner surface of the light-transparent cover 4 moves to the surface of the effective pixel region 3 of the solid state image pickup device 2.

If the dicing is carried out in the state that the surface of the light-transparent plate 10 reverse to the surface on which the adhering section 5 is formed is affixed to the dicing tape 12, the following problem occurs. That is, the inner surface (the surface on which the adhering section 5 is formed) of the light-transparent cover 4 is not sealed but open to the outside. This permits dust (such as shavings) generated in the dicing to attach to the inner surface of the light-transparent cover 4. Accordingly, when the light-transparent cover 4 is attached opposite to the surface of the effective pixel region 3 of the solid state image pickup device 2, the dust having been attached to the inner surface of the light-transparent cover 4 moves to the surface of the effective pixel region 3 of the solid state image pickup device 2. Further, in the surface reverse to the surface on which the adhering section 5 is formed, a blur can be formed by the adhesive of the dicing tape 12. This reduces the light transmissivity or its uniformity.

FIG. 4A shows the state that a plurality of solid state image pickup devices 2 are formed simultaneously on a semiconductor wafer 20. Each solid state image pickup device 2 has an effective pixel region 3. Each solid state image pickup device 2 is defined by dividing lines 20a. FIG. 4B is a cross sectional view along the arrow line A-A in FIG. 4A.

FIG. 5A shows the situation that light-transparent covers 4 (see FIG. 3E) formed in advance on appropriate regions outside the effective pixel regions 3 are adhered via the adhering sections 5 to one surface (that has the effective pixel regions 3) of the solid state image pickup devices 2 formed on the semiconductor wafer 20. Each light-transparent cover 4 is aligned appropriately to the region outside the effective pixel region 3 in the one surface of the solid state image pickup device 2, and then adhered using a method, such as infrared irradiation and thermal setting, appropriate to the property of the adhesive used in the adhering section 5.

FIG. 5B is a cross sectional view along the arrow line A-A in FIG. 5A. The adhering section 5 seals completely the outer periphery of the space formed between the effective pixel region 3 and the light-transparent cover 4. This configuration avoids the occurrence of defects in the effective pixel region 3 caused by the entering of moisture or the entering and adhering of dust into (the surface of) the effective pixel region 3 or by scratching the surface. Further, since the adhesion of the light-transparent cover 4 (the formation of the adhering section 5) is carried out in the outside of the effective pixel region 3, no physical stress acts on the effective pixel region 3.

The solid state image pickup devices 2 to which the light-transparent covers 4 are adhered are diced (divided) appropriately along the dividing lines 20a, and then removed from the semiconductor wafer 20, so that solid state imaging devices (1) are formed. It should be noted that in the surface on which the effective pixel region 3 is formed, regions for bonding pads (not shown) for connecting the solid state image pickup device 2 to an external circuit (not shown) and other regions are arranged outside the light-transparent cover 4 (adhering section 5). Further, the subsequent assembling process is carried out in the state that the effective pixel region 3 is protected. This avoids the possibility of damaging the effective pixel region 3 when the solid state imaging device (1) is transferred using a vacuum chuck handler or the like.

### [Embodiment 3]

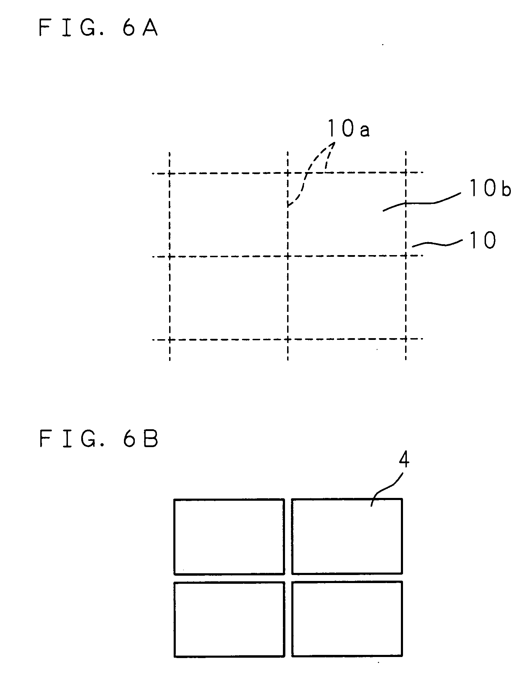

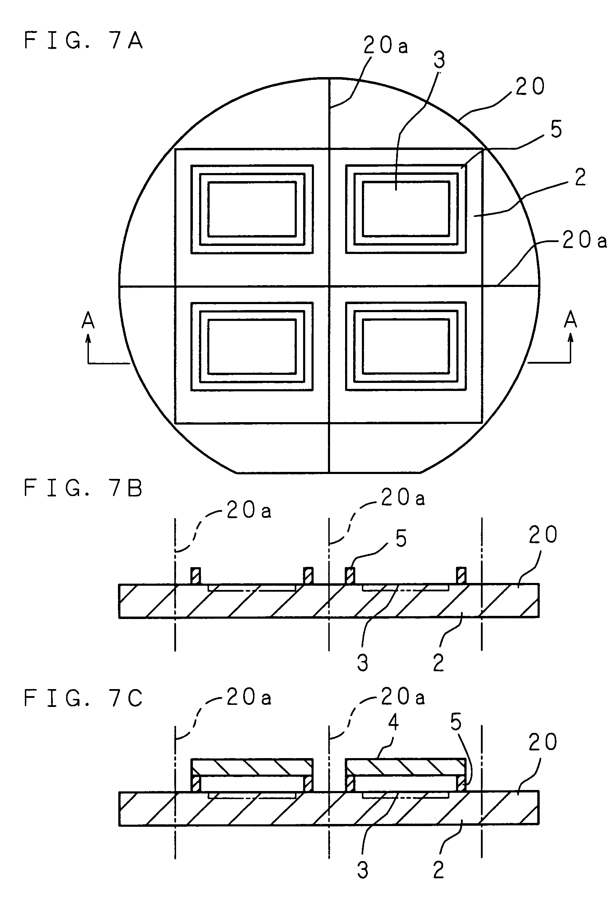

FIGS. 6A-7C are diagrams illustrating a method of solid state imaging device fabrication according to Embodiment 3 of the invention. More specifically, FIGS. 6A and 6B are diagrams illustrating the process of formation of light-transparent covers. FIGS. 7A-7C are diagrams illustrating the process that the light-transparent covers formed in FIGS. 6A and 6B are adhered to one surface (that has the effective pixel regions) of the solid state image pickup devices formed on a semiconductor wafer.

FIG. 6A shows a large-area light-transparent plate 10 composed of a glass plate or the like. The light-transparent plate 10 has a large area, and hence comprises a large number of cover corresponding regions 10b having boundaries indicated by dividing lines 10a. The area of the cover corresponding region 10b is adjusted appropriately such as to have the same planar dimensions as the light-transparent cover 4 when divided in a later process. FIG. 6B shows the state that the light-transparent plate 10 is diced along the dividing lines 10a, so that the cover corresponding regions (10b) are divided into individual pieces such as to form light-transparent covers 4. This division can be carried out using a dicing saw similarly to Embodiment 2.

FIG. 7A shows the state that adhering sections 5 are patterned in the regions outside the effective pixel regions 3 of the solid state image pickup devices 2 in one surface (that has the effective pixel regions 3) of the semiconductor wafer 20 on which a large number of solid state image pickup devices 2 are formed simultaneously. FIG. 7B is a cross sectional view along the arrow line A-A in FIG. 7A. Adhesive in which photosensitive adhesive and thermosetting resin are mixed is uniformly applied onto the surface of the semiconductor wafer 20 on which the solid state image pickup devices 2 are formed. Then, the adhesive is patterned by means of a known photolithography technique, so that the adhering section 5 is formed in each solid state image pickup device 2.

That is, in the present embodiment, the adhering sections 5 are formed simultaneously in a plurality of the solid state image pickup devices 2 having been formed simultaneously on the semiconductor wafer 20. This simultaneous formation of a large number of the adhering sections 5 improves the productivity. It should be noted that in the surface on which the effective pixel region 3 is formed, regions for bonding pads (not shown) for connecting the solid state image pickup device 2 to an external circuit (not shown) and other regions are arranged outside the adhering section 5.

FIG. 7C shows the state that light-transparent covers 4 (see FIG. 6B) formed in advance are adhered to the adhering sections 5 of the solid state image pickup devices 2 formed on the semiconductor wafer 20. Each light-transparent cover 4 is aligned and placed on the adhering section 5, and then adhered to the adhering section 5 by infrared irradiation or thermal setting. The adhering section 5 seals completely the outer periphery of the space formed between the effective pixel region 3 and the light-transparent cover 4. This configuration avoids the occurrence of defects in the effective pixel region 3 caused by the entering of moisture or the entering and adhering of dust into (the surface of) the effective pixel region 3 or by scratching the surface. The solid state image pickup devices 2 to which the light-transparent covers 4 are adhered are diced (divided) appropriately along the dividing lines 20a, and then removed from the semiconductor wafer 20, so that solid state imaging devices (1) are formed.

### [Embodiment 4]

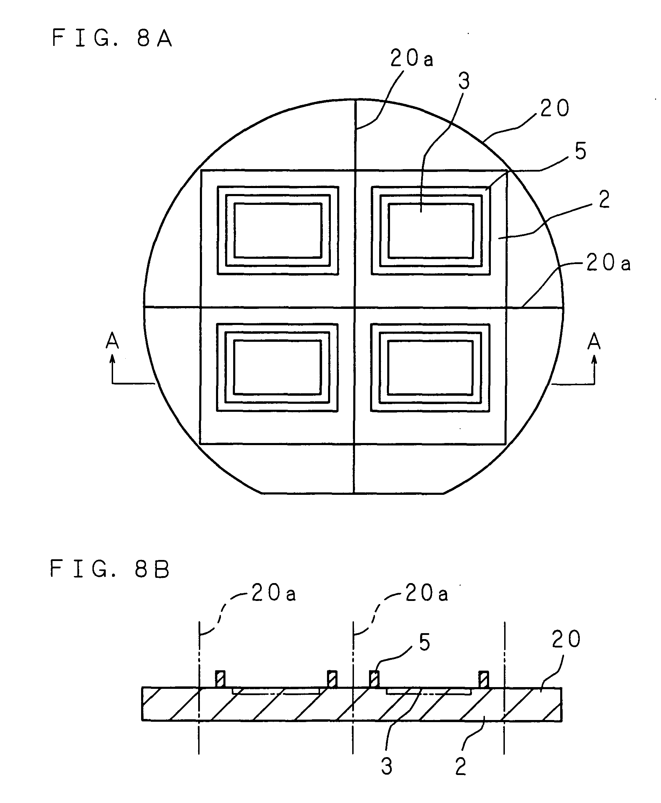

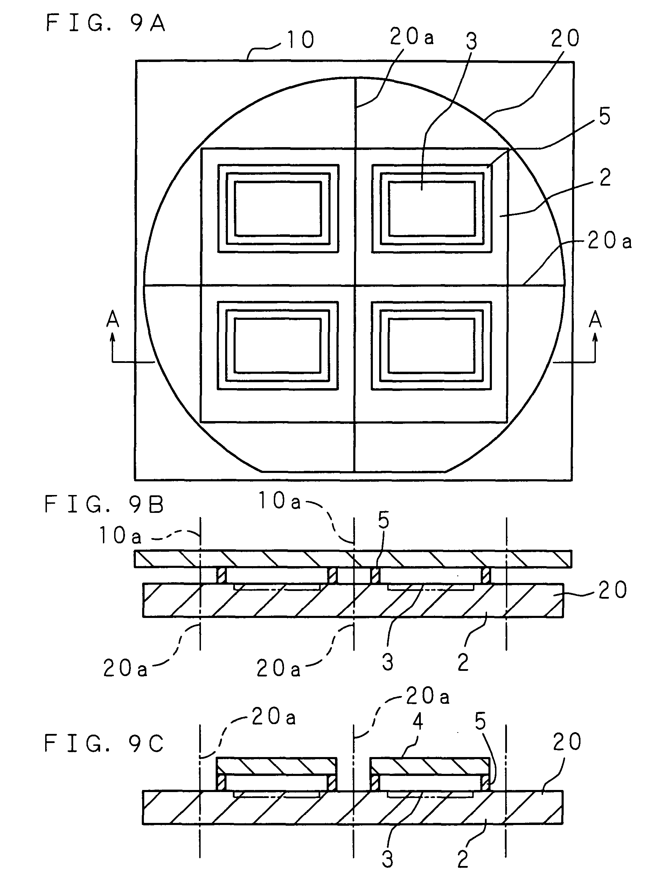

FIGS. 8A-9C are diagrams illustrating a method of solid state imaging device fabrication according to Embodiment 4 of the invention. More specifically, FIGS. 8A and 8B are diagrams illustrating the state that adhering sections are formed in one surface (that has the effective pixel regions) of solid state image pickup devices formed on a semiconductor wafer. FIGS. 9A-9C are diagrams illustrating the process that after a light-transparent plate is adhered to the semiconductor wafer of FIGS. 8A and 8B, the light-transparent plate is divided so as to form light-transparent covers.

FIG. 8A shows the state that adhering sections 5 are patterned in the regions outside the effective pixel regions 3 of the solid state image pickup devices 2 in one surface (that has the effective pixel regions 3) of the semiconductor wafer 20 on which a large number of solid state image pickup devices 2 are formed simultaneously. FIG. 8B is a cross sectional view along the arrow line A-A in FIG. 8A. This state is the same as that of FIGS. 7A and 7B of Embodiment 3. The process conditions such as the adhesive are also the same as those of the other embodiments.

FIG. 9A shows the state that a light-transparent plate 10 is adhered to the semiconductor wafer 20 of FIGS. 8A and 8B in which the adhering sections 5 are formed on the solid state image pickup devices 2. The light-transparent plate 10 is placed appropriately on the adhering sections 5 of the semiconductor wafer 20, and then adhered to the adhering sections 5 by infrared irradiation or thermal setting. Since the adhering section 5 is formed in advance on each solid state image pickup device 2, precise alignment of the light-transparent plate 10 is not necessary. Further, general alignment is sufficient between the semiconductor wafer 20 and the light-transparent plate 10. That is, individual alignment of the light-transparent plate 10 to each solid state image pickup device 2 is unnecessary.

FIG. 9B is a cross sectional view along the arrow line A-A in FIG. 9A. The entirety of the semiconductor wafer 20 is adhered to and covered with the light-transparent plate 10. This permits storage and carriage in the state that the effective pixel regions are securely protected. The adhering section 5 seals completely the outer periphery of the space formed between the effective pixel region 3 and the light-transparent cover 4. This configuration avoids the occurrence of defects in the effective pixel region 3 caused by the entering of moisture or the entering and adhering of dust into (the surface of) the effective pixel region 3 or by scratching the surface.

FIG. 9C shows the state that the light-transparent plate 10 adhered to the semiconductor wafer 20 is diced appropriately along the dividing lines 10a, so as to form light-transparent covers 4. That is, after the light-transparent plate 10 is adhered to the semiconductor wafer 20, the light-transparent plate 10 is divided so as to form the light-transparent covers 4. The solid state image pickup devices 2 to which the light-transparent covers 4 are adhered are diced (divided) appropriately along the dividing lines 20a, and then removed from the semiconductor wafer 20, so that solid state imaging devices (1) are formed.

The method described here is that the adhering sections 5 are patterned on the solid state image pickup devices 2 (see FIG. 8B) so that the semiconductor wafer 20 and the light-transparent plate 10 are adhered to each other, and that the light-transparent plate 10 is then diced so as to form the light-transparent covers 4. However, an alternative method may be used that the adhering sections 5 are patterned on the light-transparent plate 10 (see FIG. 3B) so that the semiconductor wafer 20 and the light-transparent plate 10 are adhered to each other, and that the light-transparent plate 10 is then diced so as to form the light-transparent covers 4. In this case, the adhering sections 5 formed on the light-transparent plate 10 are aligned appropriately to the effective pixel regions 3 of the solid state image pickup devices 2.

In Embodiments 2-4, in the dicing of the light-transparent plate 10 and the semiconductor wafer 20, the configuration of the effective pixel region 3 prevents the shavings generated in the dicing from entering the region (that is, the adhering section 5 seals the outer periphery of the effective pixel region 3, and the like). Further, before the solid state image pickup devices 2 are divided into individual pieces, the light-transparent covers 4 are adhered and formed opposite to the effective pixel regions 3. This avoids defects such as the attachment of dust and the occurrence of damage to the surface of the effective pixel regions 3 in the processes after the dividing of the solid state image pickup devices 2 into individual pieces, so that the fraction defective is reduced in the process of assembling the solid state image pickup devices 2 especially after the dividing into individual pieces.

Further, the planar dimensions of the light-transparent cover 4 are smaller than those of the solid state image pickup device 2. This realizes a small solid state imaging device (1) of a chip size or the like. In the processes after the light-transparent cover 4 is adhered, the cleanness of the surroundings (production environment) does not need strict control. This simplifies the process, and hence reduces fabrication cost.

### [Embodiment 5]

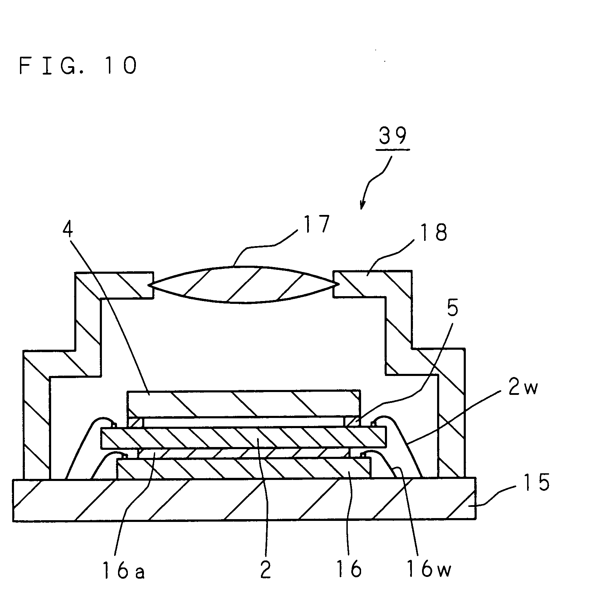

FIG. 10 is a cross sectional view showing schematic configuration of an optical device module according to Embodiment 5 of the invention. The optical device module 39 is, for example, a camera module. A lens 17 for acquiring the outside light onto a wiring board 15 and a lens retainer 18 for retaining the lens 17 are attached to a wiring board 15. A digital signal processor (DSP, hereafter) 16 is mounted on the wiring board 15 composed of a printed wiring board or a ceramic substrate. The DSP 16 serves as a controlling section (image processor) which controls the operation of a solid state imaging device 1 (solid state image pickup device 2), and processes appropriately a signal outputted from the solid state imaging device 1 (solid state image pickup device 2) so as to generate a necessary signal to the optical device. Connection terminals of the DSP 16 are wire-bonded by bonding wires 16w to wiring (not shown) formed on the wiring board 15, so as to be connected electrically.

A solid state image pickup device 2 of the present invention is mounted via a spacer 16a on the DSP 16 fabricated in the form of a semiconductor chip. Connection terminals (bonding pads 6, see FIG. 2A) of the solid state image pickup device 2 are wire-bonded by bonding wires 2w to wiring (not shown) formed on the wiring board 15, so as to be connected electrically. A light-transparent cover 4 is adhered by an adhering section 5 to the solid state image pickup device 2 according to the invention, while the light-transparent cover 4 is arranged opposite to the lens 17. That is, the solid state image pickup device 2 is arranged inside the lens retainer 18. Further, the planar dimensions of the light-transparent cover 4 are smaller than those of the solid state image pickup device 2. This permits the size reduction of the lens retainer to a practical limit, and hence realizes a small solid state imaging device of a chip size or the like.

### [Embodiment 6]

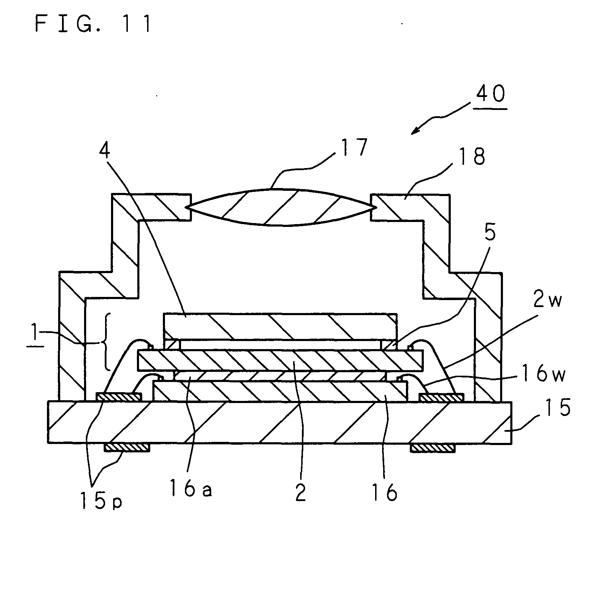

FIG. 11 is a cross sectional view showing schematic configuration of an optical device module according to Embodiment 6 of the invention. Like parts to Embodiments 1-5 are designated by like numerals, and hence detailed description is omitted. Further, its plan view is omitted. However, its basic plan-view shape is a rectangle (a square or a genuine rectangle), and may be changed appropriately when necessary.

The optical device module 40 comprises: a wiring board 15 on which wiring 15p is formed; a solid state imaging device 1; a DSP 16 serving as an image processor which controls the operation of the solid state imaging device 1 (solid state image pickup device 2), and processes a signal outputted from the solid state imaging device 1; and a lens retainer 18 arranged opposite to the solid state imaging device 1 and serving as an optical path defining unit for defining an optical path to the solid state imaging device 1. Preferably, the solid state imaging device 1 has the configuration of Embodiment 1, and is fabricated by the method of fabrication according to Embodiments 2-4. However, the configuration and the method of fabrication of the solid state imaging device 1 are not limited to those of Embodiments 1-4. That is, the solid state imaging device 1 may have any configuration as long as the light-transparent cover 4 having planar dimensions smaller than those of the solid state image pickup device 2 is attached (adhered by the adhering section 5) opposite to the effective pixel region (3) of the solid state image pickup device 2.

The optical device module 40 is generally assembled as follows. First, the DSP 16 is placed and adhered (die-bonded) on the wiring board 15 on which the wiring 15p is formed. Then, the connection terminals of the DSP 16 are connected by the bonding wires 16w to the wiring 15p formed on the wiring board 15. After that, the solid state imaging device 1 (the surface of the solid state image pickup device 2 on which the light-transparent cover 4 is not attached) is stacked (placed) and adhered (die-bonded) on the DSP 16 via the spacer 16a composed of an insulating sheet.

Then, the connection terminals of the solid state imaging device 1 (solid state image pickup device 2) are connected by the bonding wires 2w to the wiring 15p. The DSP 16 is preferably in the form of a semiconductor chip (bare chip) from the perspective of size reduction. However, the DSP 16 may be packaged (resin-sealed) using a chip-size package technique or the like. When the DSP 16 is packaged, the spacer 16a and the bonding wires 16w are unnecessary. In this case, the connection terminals extracted from the package are connected directly to the wiring 15p, while the solid state imaging device 1 is adhered directly on the package.

After that, the solid state imaging device 1 (light-transparent cover 4) and the lens retainer 18 are aligned (positioned) opposite to each other. Then, the lens retainer 18 and the wiring board 15 are linked (by adhesion, fitting, or the like) to each other, so that the optical device module 40 is completed. In addition to the function of retaining the lens 17, the lens retainer 18 has the function of an optical path defining unit for defining the optical path to the solid state imaging device 1 (light-transparent cover 4) and the function of protecting means for protecting the solid state imaging device 1, the DSP 16, and the like against the outer environment. The lens 17 and the lens retainer 18 are preferable integrated to each other. However, the invention is not limited to this, and the lens 17 may be assembled separately from the lens retainer 18. This configuration that the lens 17 is assembled separately permits an arbitrary change in the specification of the lens, and hence realizes an optical device module having wider universality.

In the optical device module 40, the light-transparent cover 4 having planar dimensions smaller than those of the solid state image pickup device 2 is attached opposite to the effective pixel region (3) of the solid state image pickup device 2. This allows the shape of the lens retainer 18 to approach the chip size of the solid state image pickup device 2, and hence realizes a small optical device module. In particular, when used as a camera module, this optical device module serves as a small camera having good portability.

In the optical device module 40, the light projected from an object through the lens 17 onto the solid state imaging device 1 (solid state image pickup device 2) is converted into an electric signal. The DSP 16 performs digital processing on this electric signal, and then outputs the signal. The optical device module 40 outputs the signal to the outside via the wiring 15p formed on the surface of the wiring board 15 reverse to the surface on which the DSP 16 is mounted.

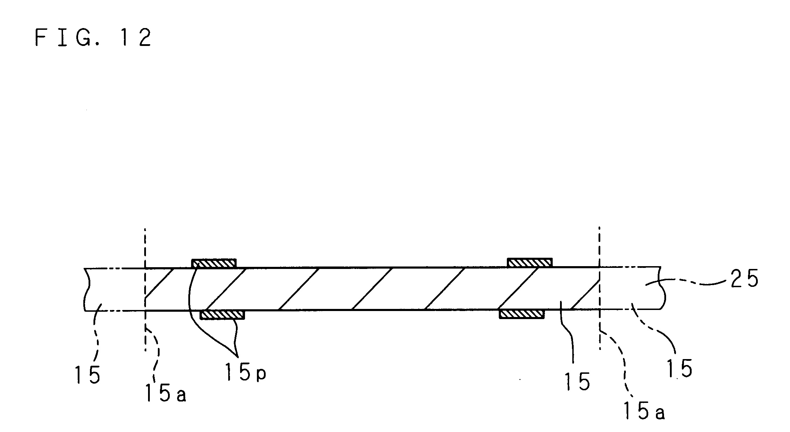

FIGS. 12-15 are process diagrams showing cross sectional views of the fabrication processes of an optical device module according to Embodiment 6 of the invention. The fabrication processes of the optical device module 40 are described below in further detail with reference to FIGS. 12-15. FIG. 12 shows a multiple wiring board 25 formed by linking a plurality of wiring boards 15. The multiple wiring board 25 is formed by linking a plurality of wiring boards 15 each corresponding to an optical device module 40, in the shape of a matrix, a long sheet, or the like. The use of the multiple wiring board 25 permits simultaneous fabrication of a plurality of the optical device modules 40 each corresponding to each wiring board 15.

Regions each corresponding to a wiring board 15 are defined along the dividing lines 15a on the multiple wiring board 25, and divided eventually along the dividing lines 15a into individual wiring boards 15 (individual optical device modules 40). Described below are the processes of simultaneous fabrication of a plurality of optical device modules 40 by using the multiple wiring board 25. However, in place of the use of the multiple wiring board 25, the optical device module 40 may be fabricated using an intrinsically separated wiring board 15.

The multiple wiring board 25 is composed of a ceramic substrate, a glass epoxy substrate, an alumina substrate, or the like. The multiple wiring board 25 has a thickness of 0.05-2.00 mm or the like from the perspective of mechanical strength. On the multiple wiring board 25, wiring 15p is formed (patterned) in correspondence to each wiring board 15. The figure shows the case that the wiring 15p is formed on both sides of the multiple wiring board 25. The wiring 15p may be formed only on one side of the multiple wiring board 25. However, from the perspective of assembling density, it is preferable that the wiring 15p is formed on both sides, so that terminals are extracted from both sides of the wiring board 15, that is, from the side on which solid state imaging device 1 is mounted and its reverse side.

The wiring 15p sections formed on both sides are connected to each other in the inside of the wiring board 15 (not shown). The wiring 15p is designed appropriately depending on the required specification of the optical device module 40. Since adjacent wiring boards 15 linked to each other are processed similarly and simultaneously, the fabrication processes are described only for one wiring board 15, and hence description for the other wiring boards 15 is omitted appropriately.

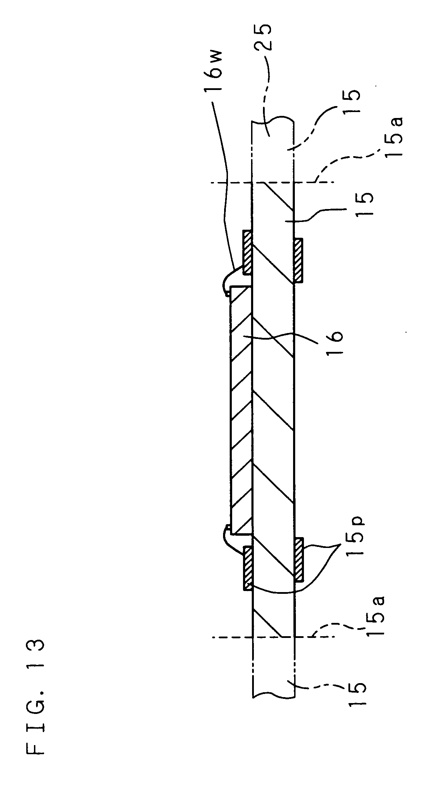

FIG. 13 shows the situation of assembling of the DSP 16. The DSP 16 is placed and adhered by die-bonding on the surface of the wiring board 15 (multiple wiring board 25) on which the wiring 15p is formed. Then, (the connection terminals of) the DSP 16 is wire-bonded and connected electrically by the bonding wires 16w to the wiring 15p. The method of connection used here may be flip chip bonding in place of the wire bonding.

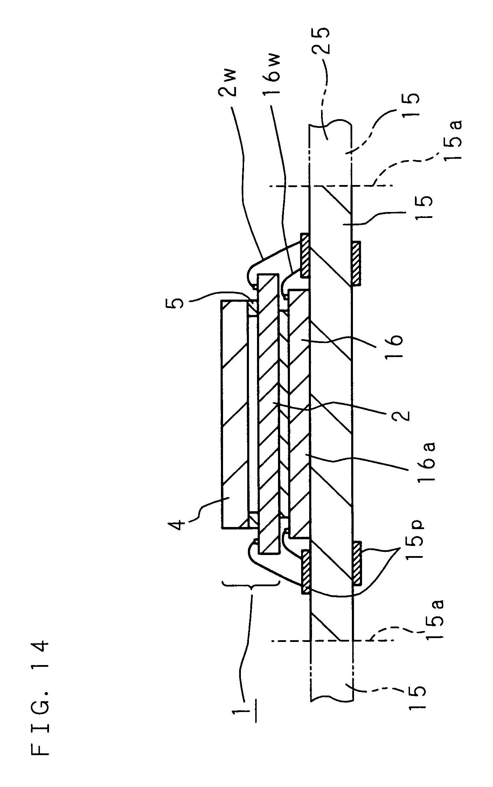

FIG. 14 shows the situation of assembling of the solid state imaging device 1. The spacer 16a composed of an insulating sheet is placed and adhered on the DSP 16. In addition to the insulating property and the adhesion property, the spacer 16a preferably has somewhat buffering property in order to avoid any influence to the surface of the DSP 16 during the adhesion. The spacer 16a is composed of a sheet of acrylic resin or the like having a thickness of 0.05-1.00 mm. Then, the solid state imaging device 1 is placed on the spacer 16a, so that the solid state imaging device 1 (the surface reverse to the surface on which the effective pixel region of the solid state image pickup device 2 is formed) is adhered (die-bonded). Then, the solid state imaging device 1 (the connection terminals of the solid state image pickup device 2) is wire-bonded and connected electrically by the bonding wires 2w to the wiring 15p.

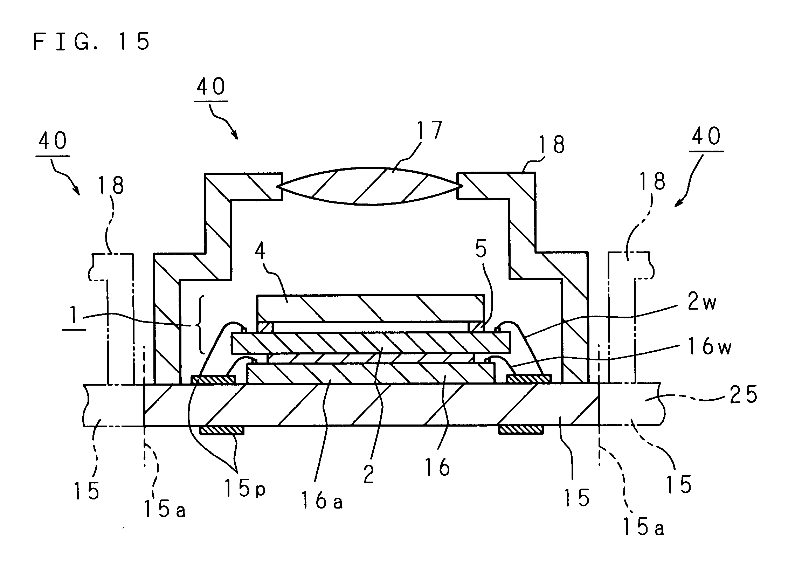

FIG. 15 shows the situation of assembling of the lens retainer 18. In each wiring board 15, the lens retainer 18 (lens 17) and the solid state imaging device 1 are aligned appropriately to each other. Then, the lens retainer 18 is adhered to the wiring board 15 using adhesive resin. The lens retainer 18 and the wiring board 15 may be linked (fixed) to each other using another means such as a screw and a mating mechanism. The lens 17 is preferably integrated into the lens retainer 18. However, the lens 17 may be assembled separately. The lens retainer 18 has the function of allowing the light from the object to be incident on the solid state imaging device 1 (solid state image pickup device 2) and the function of shutting out the light other than that from the object, so as to define a desired optical path. Further, the lens retainer 18 may have the function of a shutter for shutting out the light from the object which is otherwise to be incident on the solid state image pickup device 2.

As a result of these processes, a plurality of optical device modules 40 (of integrated lens type) corresponding to the respective wiring boards 15 are formed on the multiple wiring board 25. After that, a plurality of the optical device modules 40 formed on the multiple wiring board 25 are divided (cut out) into individual pieces along the dividing lines 15a using a dicing machine, a router, a metal mold press, or the like. As a result, individual optical device modules 40 (FIG. 11) are formed.

When the lens and the lens retainer are integrated, and when the lens retainer is linked to the wiring board, the surface of the solid state imaging device is securely protected in the subsequent processes. This configuration also permits further size reduction of the optical device module. Further, the configuration permits direct alignment between the lens and the solid state imaging device, and hence improves the uniformity in the optical characteristics of the optical device modules. In the above-mentioned example, the lens retainers 18 are those separated from each other in correspondence to the respective wiring boards 15. However, a multiple lens retainer formed by linking a plurality of lens retainers 18 may be used corresponding to the multiple wiring board 25. The use of the multiple lens retainer simplifies further the process of alignment between the lens retainer 18 and the solid state imaging device 1.

In this embodiment, the solid state imaging device in which the light-transparent cover having planar dimensions smaller than those of the solid state image pickup device is attached (adhered by the adhering section) opposite to the effective pixel region of the solid state image pickup device is built into the optical device module. This permits the size reduction (thickness reduction and weight reduction) of the optical device module. Since the solid state imaging device (solid state image pickup device) the effective pixel region of which is protected by the light-transparent cover is assembled into the optical device module, the attachment of dust is avoided to the surface of the effective pixel region of the solid state imaging device (solid state image pickup device) in the processes after the assembling of the solid state imaging device. This permits the fabrication even in a production environment of low cleanness.

This realizes an optical device module and a method of its fabrication that permit yield improvement, process simplification, and price reduction. Further, a multiple wiring board formed by linking a plurality of wiring boards is used. This permits simultaneous fabrication of a plurality of optical device modules, and hence improves further the production efficiency of the optical device module. Further, this achieves uniformity in the characteristics of the optical device modules.

### [Embodiment 7]

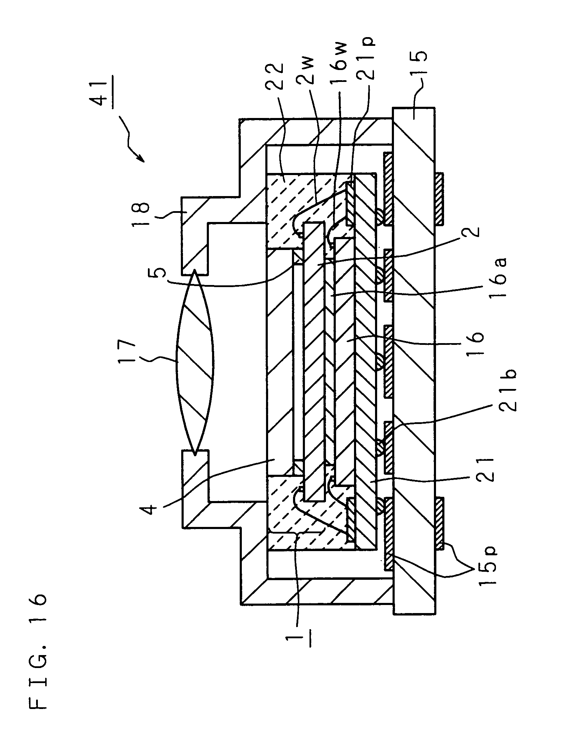

FIG. 16 is a cross sectional view showing schematic configuration of an optical device module according to Embodiment 7 of the invention. Like parts to Embodiments 1-6 are designated by like numerals, and hence detailed description is omitted. Further, its plan view is omitted. However, its basic plan-view shape is a rectangle (a square or a genuine rectangle), and may be changed appropriately when necessary.

The optical device module 41 comprises: a module component wiring board 21 on which wiring 21p is formed; a solid state imaging device 1; a DSP 16 serving as an image processor; a solid state imaging module component 22 in which the module component wiring board 21, the DSP 16, and the solid state imaging device 1 are resin-sealed in the state that the surface of the light-transparent cover 4 is exposed; and a lens retainer 18 arranged opposite to the solid state imaging device 1 and serving as an optical path defining unit for defining an optical path to the solid state imaging device 1. The optical device module 41 may further comprise a wiring board 15 when appropriate. The solid state imaging device 1 has the same configuration as that of Embodiment 6. That is, the solid state imaging device 1 may have any configuration as long as the light-transparent cover 4 having planar dimensions smaller than those of the solid state image pickup device 2 is attached (adhered by the adhering section 5) opposite to the effective pixel region (3) of the solid state image pickup device 2.

The optical device module 41 is generally assembled as follows. First, the DSP 16 is placed and adhered (die-bonded) on the module component wiring board 21 on which the wiring 21p is formed. Then, the connection terminals of the DSP 16 are connected by the bonding wires 16w to the wiring 21p formed on the module component wiring board 21. After that, the solid state imaging device 1 (the surface of the solid state image pickup device 2 on which the light-transparent cover 4 is not attached) is stacked (placed) and adhered (die-bonded) on the DSP 16 via the spacer 16a composed of an insulating sheet. Then, the connection terminals of the solid state imaging device 1 (solid state image pickup device 2) are connected by the bonding wires 2w to the wiring 21p.

After that, the surface of the module component wiring board 21 on which the DSP 16 is adhered, the DSP 16, and the solid state imaging device 1 are resin-sealed in the state that the surface of the light-transparent cover 4 is exposed, so that the solid state imaging module component 22 is formed. Since the module component wiring board 21, the DSP 16, and the solid state imaging device 1 are resin-sealed into the solid state imaging module component 22, the DSP 16 is preferably in the form of a semiconductor chip (bare chip) from the perspective of size reduction.

After that, external terminals 21b of the solid state imaging module component 22 (solid state imaging device 1 or light-transparent cover 4) are adhered (connected) to the wiring board 15. Further, the solid state imaging module component 22 (solid state imaging device 1 or light-transparent cover 4) and the lens retainer 18 are aligned (positioned) opposite to each other. Then, the lens retainer 18 and, for example, the wiring board 15 are linked (by adhesion, fitting, or the like) to each other, so that the optical device module 41 is completed. The configuration and the functions of the lens retainer 18 (lens 17) are similar to those of Embodiment 6, and hence detailed description is omitted. The lens retainer 18 may be linked (by adhesion, fitting, or the like) to the solid state imaging module component 22 in place of the wiring board 15. Further, the lens retainer 18 may be linked to both of the wiring board 15 and the solid state imaging module component 22. In either case, alignment is necessary between the solid state imaging module component 22 (solid state imaging device 1) and the lens retainer 18 serving as the optical path defining unit.

In the solid state imaging module component 22, the surface of the module component wiring board 21 on which the DSP 16 is adhered is resin-sealed and thereby integrated (packaged) with the DSP 16 and the solid state imaging device 1. The solid state imaging module component 22 is preferably formed (resin-sealed) using a chip-size package technique, while the external terminals 21b connected to the wiring 21p are formed on the surface reverse to the surface on which the DSP 16 is adhered. This resin sealing of the solid state imaging module component 22 by the chip-size package technique permits further size reduction.

When the DSP 16 and the solid state imaging device 1 are in the form of bare chips, the solid state imaging module component 22 serves also as protecting means for protecting securely these bare chips against the outer environment, so as to improve environmental durability (such as against moisture). The solid state imaging module component 22 is preferably in the form of a chip-size package from the perspective of size reduction. However, another method may be used in the integrating and packaging.

When the external terminals 21b of the module component wiring board 21 are formed in a protruding shape, connection to the outside (such as the wiring board 15) becomes easy. The use of the wiring board 15 in addition to the module component wiring board 21 ensures the mechanical strength of the optical device module. The lens retainer 18 may be linked to the solid state imaging module component 22, while the external terminals 21b may be connected to flexible film wiring or the like in place of the wiring board 15 when appropriate.

In the optical device module 41, the light-transparent cover 4 having planar dimensions smaller than those of the solid state image pickup device 2 is attached opposite to the effective pixel region (3) of the solid state image pickup device 2. This allows the shape of the lens retainer 18 to approach the chip size of the solid state image pickup device 2, and hence realizes a small optical device module. In particular, when used as a camera module, this optical device module serves as a small camera having good portability.

In the optical device module 41, the light projected from an object through the lens 17 onto the solid state imaging device 1 (solid state image pickup device 2) is converted into an electric signal. The DSP 16 performs digital processing on this electric signal, and then outputs the signal. The optical device module 41 outputs the signal via the external terminals 21b of the module component wiring board 21 or via the wiring 15p formed on the surface of the wiring board 15 reverse to the surface on which the solid state imaging module component 22 is mounted.

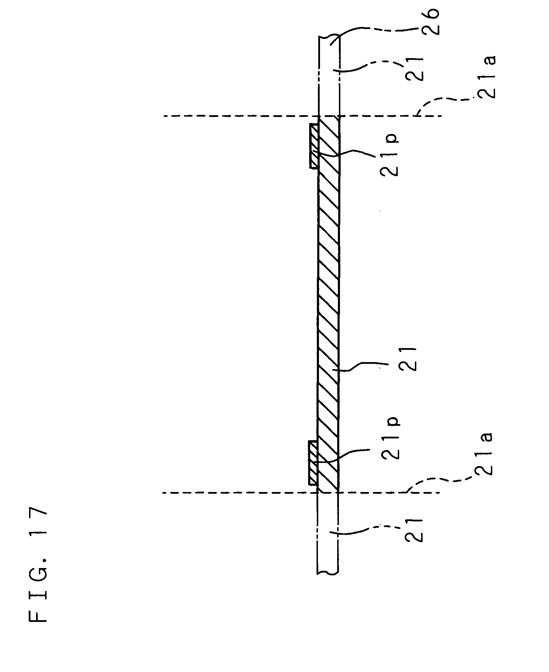

FIGS. 17-24 are process diagrams showing cross sectional views of the fabrication processes of an optical device module according to Embodiment 7 of the invention. The fabrication processes of the optical device module 41 are described below in further detail with reference to FIGS. 17-24. FIG. 17 shows a multiple module component wiring board 26 formed by linking a plurality of module component wiring boards 21. The multiple module component wiring board 26 is formed by linking a plurality of module component wiring boards 21 each corresponding to a solid state imaging module component 22 (serving as a component of an optical device module 41), in the shape of a matrix, a long sheet, or the like. The use of the multiple module component wiring board 26 permits simultaneous fabrication of a plurality of the solid state imaging module components 22 each corresponding to each module component wiring board 21.

Regions each corresponding to a module component wiring board 21 are defined along the dividing lines 21a on the multiple module component wiring board 26, and divided eventually along the dividing lines 21a into individual module component wiring boards 21 (individual solid state imaging module components 22). Described below are the processes of simultaneous fabrication of a plurality of solid state imaging module components 22 by using the multiple module component wiring board 26. However, in place of the use of the multiple module component wiring board 26, the solid state imaging module component 22 may be fabricated using an intrinsically separated module component wiring board 21.

From the perspective of the size reduction and the use of the chip-size packaging, the multiple module component wiring board 26 is preferably composed of polyimide resin or the like the thickness of which is easily reduced. The multiple module component wiring board 26 has a thickness of 0.025-1.00 mm or the like. On the multiple module component wiring board 26, wiring 21p is formed (patterned) in correspondence to each module component wiring board 21. The figure shows the case that the wiring 21p is formed only on one side (the upper surface in the figure) of the module component wiring board 21. However, when the external terminals 21b are formed on the other side of the module component wiring board 21, wiring for the formation of the external terminals 21b is formed also on this other side appropriately (not shown).

When the wiring 21p is formed on both sides, the wiring 21p sections formed on both sides are connected to each other in the inside of the module component wiring board 21 (not shown). The wiring 21p is designed appropriately depending on the required specification of the solid state imaging module component 22 (corresponding to the optical device module 41). Since adjacent module component wiring boards 21 linked to each other are processed similarly and simultaneously, the fabrication processes are described only for one module component wiring board 21, and hence description for the other module component wiring boards 21 is omitted appropriately.

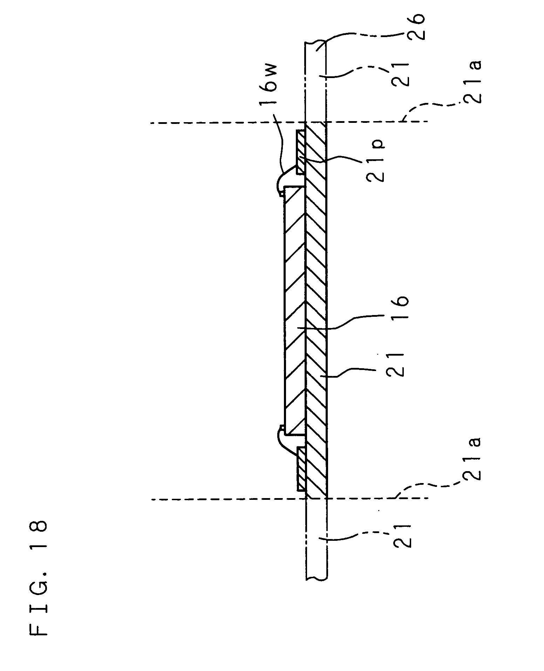

FIG. 18 shows the situation of assembling of the DSP 16. The DSP 16 is placed and adhered by die-bonding on the surface of the module component wiring board 21 (multiple module component wiring board 26) on which the wiring 21p is formed. Then, (the connection terminals of) the DSP 16 is wire-bonded and connected electrically by the bonding wires 16w to the wiring 21p. The method of connection used here may be flip chip bonding in place of the wire bonding.

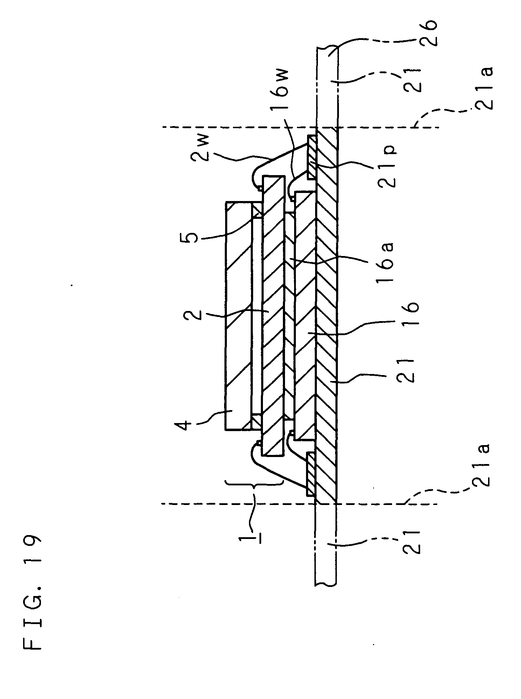

FIG. 19 shows the situation of assembling of the solid state imaging device 1. The solid state imaging device 1 is assembled similarly to Embodiment 6, and hence detailed description is omitted.

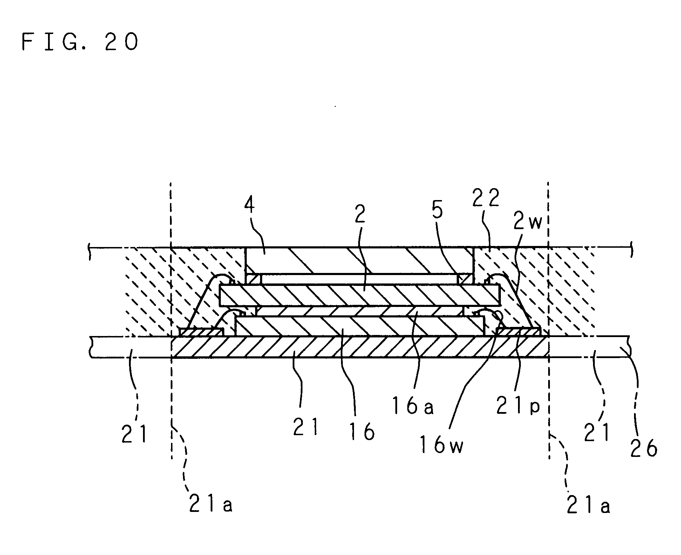

FIG. 20 shows the situation of resin sealing of the solid state imaging module component 22. The surface of the module component wiring board 21 on which the DSP 16 is adhered is resin-sealed together with the DSP 16 and the solid state imaging device 1, so that the solid state imaging module component 22 is formed. At that time, the surface of the light-transparent cover 4 of the solid state imaging device 1 is exposed. The sealing resin used here may be an appropriate epoxy resin used in ordinary chip-size packaging or the like. From the perspective of the simplicity in the sealing process, adjacent module component wiring boards 21 (solid state imaging module components 22) in the multiple module component wiring board 26 are preferably resin-sealed in an integrated manner as shown in the figure. However, an appropriate spacer (such as a metal mold) may be arranged in advance along the dividing lines 21a, so that the sealing resin may be formed in an intrinsically separated manner.

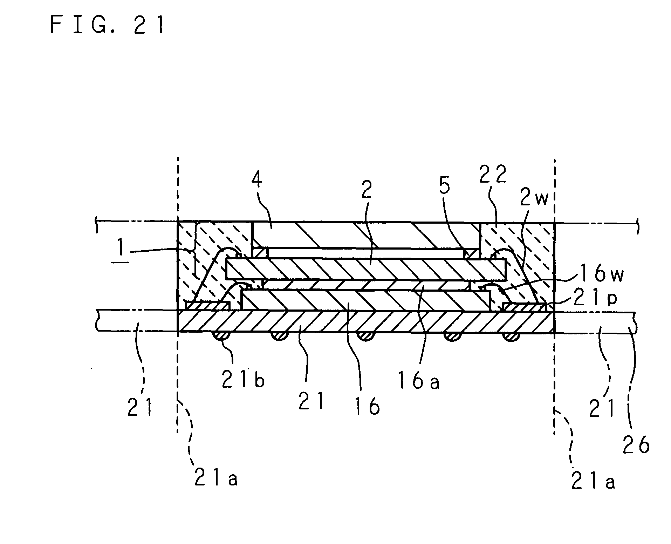

FIG. 21 shows the situation of the formation of the external terminals 21b of the solid state imaging module component 22. The external terminals 21b connected to the wiring 21p are formed on the surface of the module component wiring board 21 reverse to the surface on which the DSP 16 is adhered. The wiring 21p and the external terminals 21b are connected to each other in the inside of the module component wiring board 21 (not shown). The external terminal 21b has the protruding shape of a solder ball, so as to permit easy connection to the wiring board 15 or the like. A solder bump may be used in place of the solder ball. Further, the external terminals 21b may be composed of gold or the like in place of the solder.

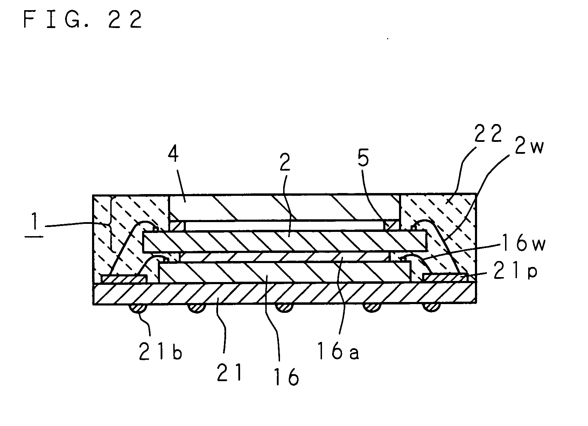

After the formation of the external terminals 21b of the solid state imaging module component 22, a plurality of the solid state imaging module components 22 formed on the multiple module component wiring board 26 are divided along the dividing lines 21a. Adjacent solid state imaging module components 22 (module component wiring boards 21) resin-sealed in an integrated manner on the multiple module component wiring board 26 are divided (cut out) into individual pieces using a dicing machine, a router, a metal mold press, or the like. As a result, individual solid state imaging module components 22 (FIG. 22) serving as intermediate components are formed. When the resin sealing is carried out in the state that the individual solid state imaging module components 22 are separated from each other, it is sufficient to divide the multiple module component wiring board 26 along the dividing lines 21a.

The use of the multiple module component wiring board 26 permits simultaneous fabrication of a plurality of the solid state imaging module components 22, and hence improves further the production efficiency of the solid state imaging module component 22. Further, this achieves uniformity in the characteristics of the solid state imaging module components 22. This improves further the production efficiency of the optical device module 41, and achieves uniformity in the characteristics of the optical device modules 41.

FIG. 22 shows the solid state imaging module component 22. The solid state imaging module component 22 is surrounded by the module component wiring board 21 and the sealing resin, and hence hardly affected by the outer environment. This permits size reduction, and also improves environmental durability (such as against moisture) and mechanical strength.

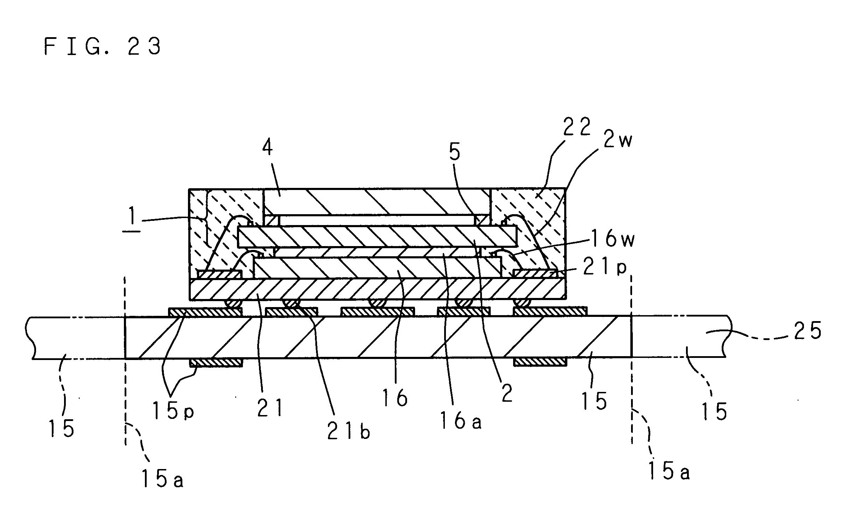

FIG. 23 shows the situation of assembling of the solid state imaging module component 22 onto the multiple wiring board 25 formed by linking a plurality of wiring boards 15. The use of the multiple wiring board 25 permits simultaneous fabrication of a plurality of the optical device modules 41 each corresponding to each wiring board 15. The multiple wiring board 25 is described in Embodiment 6, and hence detailed description is omitted. Described below are the processes of simultaneous fabrication of a plurality of optical device modules 41 by using the multiple wiring board 25. However, in place of the use of the multiple wiring board 25, the optical device module 41 may be fabricated using an intrinsically separated wiring board 15.

After the solid state imaging module component 22 is aligned and placed on the surface of the wiring board 15 (multiple wiring board 25) on which wiring 15p is formed, the wiring 15p is adhered (connected) to the external terminals 21b. When the external terminals 21b are composed of solder, the method of this connection may be soldering. Other applicable methods of adhesion (connection) include an electro-conductive adhesive and an anisotropic electro-conductive material. Since adjacent wiring boards 15 linked to each other are processed similarly and simultaneously, the fabrication processes are described only for one wiring board 15, and hence description for the other wiring boards 15 is omitted appropriately.

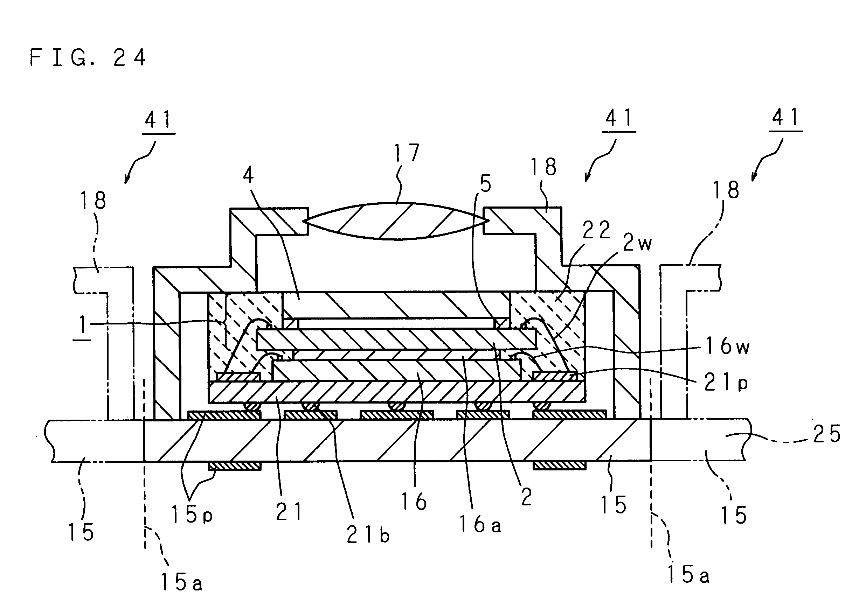

FIG. 24 shows the situation of assembling of the lens retainer 18. In each wiring board 15, the lens retainer 18 (lens 17) and the solid state imaging module component 22 (solid state imaging device 1) are aligned appropriately to each other. Then, the lens retainer 18 is adhered to the wiring board 15 using adhesive resin. The method of attachment (linkage) is the same as that of Embodiment 6, and hence detailed description is omitted. As a result of these processes, a plurality of optical device modules 41 (of integrated lens type) corresponding to the respective wiring boards 15 are formed on the multiple wiring board 25. After that, a plurality of the optical device modules 41 formed on the multiple wiring board 25 are divided (cut out) into individual pieces along the dividing lines 15a using a dicing machine, a router, a metal mold press, or the like. As a result, individual optical device modules 41 (FIG. 16) are formed.

In the above-mentioned example, after the solid state imaging module component 22 is connected to the wiring board 15, the lens retainer 18 is linked to the wiring board 15. However, another portion may be linked. For example, after the solid state imaging module component 22 is connected to the wiring board 15, the lens retainer 18 may be linked to both of the wiring board 15 and the solid state imaging module component 22. Alternatively, after the solid state imaging module component 22 is connected to the wiring board 15, the lens retainer 18 may be linked to the solid state imaging module component 22. Further alternatively, after the lens retainer 18 is connected to the solid state imaging module component 22, the solid state imaging module component 22 may be linked to the wiring board 15. Any kind of linkage may be used as long as the alignment of the solid state imaging module component 22 (solid state imaging device 1) is ensured relative to the lens retainer 18 for defining an optical path to the solid state imaging device 1. Further, a multiple lens retainer formed by linking a plurality of lens retainers 18 may be used similarly to Embodiment 6.

In the optical device module according to the present embodiment and the method of its fabrication, the solid state imaging device in which the light-transparent cover having planar dimensions smaller than those of the solid state image pickup device is attached (adhered by the adhering section) opposite to the effective pixel region of the solid state image pickup device is built into the optical device module. This permits the size reduction (thickness reduction and weight reduction) of the optical device module. Since the solid state imaging device (solid state image pickup device) the effective pixel region of which is protected by the light-transparent cover is assembled into the optical device module, the attachment of dust is avoided to the surface of the effective pixel region of the solid state imaging device (solid state image pickup device) in the processes after the assembling of the solid state imaging device. This permits the fabrication even in a production environment of low cleanness. This realizes an optical device module and a method of its fabrication that permit yield improvement, process simplification, and price reduction. Further, in the optical device module according to the present embodiment and the method of its fabrication, a multiple wiring board formed by linking a plurality of wiring boards is used. This permits simultaneous fabrication of a plurality of optical device modules, and hence improves further the production efficiency of the optical device module. Further, this achieves uniformity in the characteristics of the optical device modules.

In the present embodiment, a solid state imaging module component formed by integrating and resin-sealing a DSP (serving as an image processor) and a solid state imaging device (solid state image pickup device) is used, so as to realize an optical device module having higher environmental durability (such as against moisture) and mechanical strength. Further, this permits the assembling process of the optical device module even in a production environment of lower cleanness. Since the solid state imaging module component comprises external terminals capable of being connected to the outside by means of soldering or the like, this module component is easily assembled into another wiring board. This realizes an optical device module having high productivity.

### [Embodiment 8]

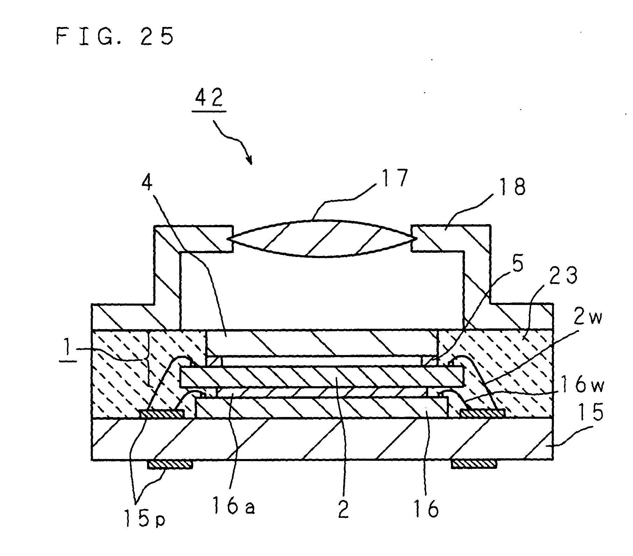

FIG. 25 is a cross sectional view showing schematic configuration of an optical device module according to Embodiment 8 of the invention. Like parts to Embodiments 1-7 are designated by like numerals, and hence detailed description is omitted. Further, its plan view is omitted. However, its basic plan-view shape is a rectangle (a square or a genuine rectangle), and may be changed appropriately when necessary.

The optical device module 42 comprises: a wiring board 15 on which wiring 15p is formed; a solid state imaging device 1; a DSP 16 serving as an image processor which controls the operation of the solid state imaging device 1 (solid state image pickup device 2), and processes a signal outputted from the solid state imaging device 1; a sealing section 23 for resin-sealing the wiring board 15, the DSP 16, and the solid state imaging device 1 in the state that the light-transparent cover 4 is exposed; and a lens retainer 18 arranged opposite to the solid state imaging device 1 and serving as an optical path defining unit for defining an optical path to the solid state imaging device 1. The solid state imaging device 1 has the same configuration as that of Embodiment 6. That is, the solid state imaging device 1 may have any configuration as long as the light-transparent cover 4 having planar dimensions smaller than those of the solid state image pickup device 2 is attached (adhered by the adhering section 5) opposite to the effective pixel region (3) of the solid state image pickup device 2.

The optical device module 42 is generally assembled as follows. First, the DSP 16 is placed and adhered (die-bonded) on the wiring board 15 on which the wiring 15p is formed. Then, the connection terminals of the DSP 16 are connected by the bonding wires 16w to the wiring 15p formed on the wiring board 15. After that, the solid state imaging device 1 (the surface of the solid state image pickup device 2 on which the light-transparent cover 4 is not attached) is stacked (placed) and adhered (die-bonded) on the DSP 16 via the spacer 16a composed of an insulating sheet. Then, the connection terminals of the solid state imaging device 1 (solid state image pickup device 2) are connected by the bonding wires 2w to the wiring 15p.

These situations are the same as those of FIGS. 12-14 of Embodiment 6. The DSP 16 is preferably in the form of a semiconductor chip (bare chip) from the perspective of size reduction. However, the DSP 16 may be packaged (resin-sealed) using a chip-size package technique or the like. When the DSP 16 is packaged, the spacer 16a and the bonding wires 16w are unnecessary. In this case, the connection terminals extracted from the package are connected directly to the wiring 15p, while the solid state imaging device 1 is adhered directly on the package.

After that, the sealing section 23 is formed that resin-seals the surface of the wiring board 15 on which the DSP 16 is adhered, the DSP 16, and the solid state imaging device 1 in the state that the surface of the light-transparent cover 4 is exposed. Then, the solid state imaging device 1 (light-transparent cover 4) and the lens retainer 18 are aligned (positioned) opposite to each other. Then, the lens retainer 18 and the sealing section 23 are linked (by adhesion, fitting, or the like) to each other, so that the optical device module 42 is completed. Since the DSP 16 and the solid state imaging device 1 are resin-sealed, the DSP 16 is preferably in the form of a semiconductor chip (bare chip) from the perspective of size reduction. The configuration and the functions of the lens retainer 18 (lens 17) are similar to those of Embodiment 6, and hence detailed description is omitted.

In the optical device module 42, the light-transparent cover 4 having planar dimensions smaller than those of the solid state image pickup device 2 is attached opposite to the effective pixel region (3) of the solid state image pickup device 2. This allows the shape of the lens retainer 18 to approach the chip size of the solid state image pickup device 2, and hence realizes a small optical device module. In particular; when used as a camera module, this optical device module serves as a small camera having good portability.

In the optical device module 42, the light projected from an object through the lens 17 onto the solid state imaging device 1 (solid state image pickup device 2) is converted into an electric signal. The DSP 16 performs digital processing on this electric signal, and then outputs the signal. The optical device module 42 outputs the signal to the outside via the wiring 15p formed on the surface of the wiring board 15 reverse to the surface on which the DSP 16 is mounted.

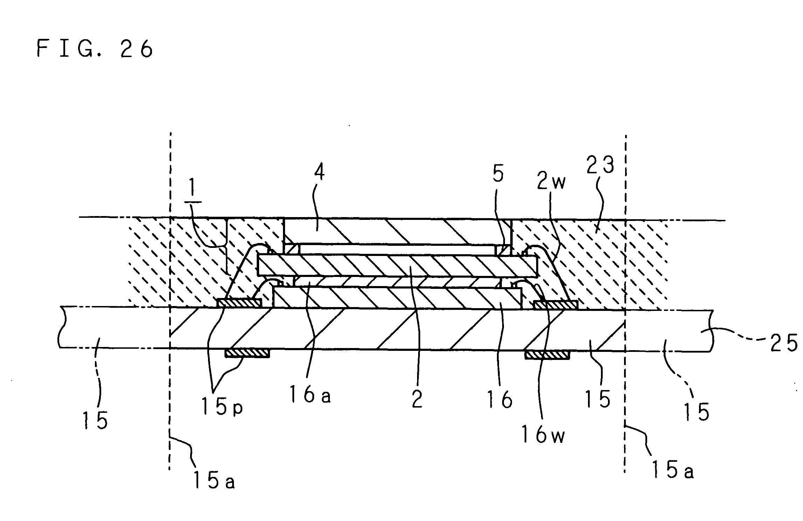

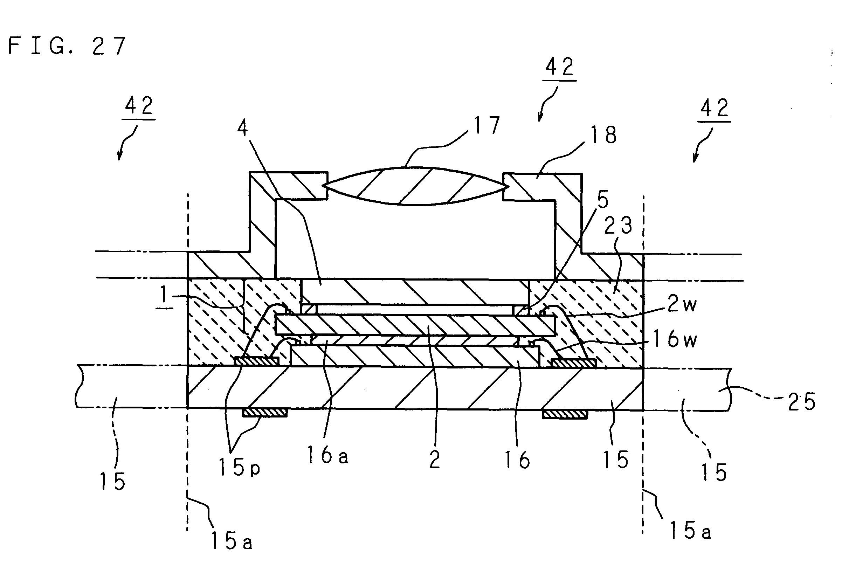

FIGS. 26 and 27 are process diagrams showing cross sectional views of the fabrication processes of an optical device module according to Embodiment 8 of the invention. The fabrication processes of the optical device module 42 are described below in further detail with reference to FIGS. 26 and 27. The processes before that of FIG. 26 are the same as those of FIGS. 12-14 of Embodiment 6, and hence description is omitted. FIG. 26 shows the situation of the formation of the sealing section 23. After the processes of FIGS. 12-14, the surface of the wiring board 15 (multiple wiring board 25) on which the DSP 16 is adhered is resin-sealed together with the DSP 16 and the solid state imaging device 1, so that the sealing section 23 is formed. At that time, the surface of the light-transparent cover 4 of the solid state imaging device 1 is exposed. The sealing resin used here may be an appropriate epoxy resin-used in ordinary chip-size packaging or transfer molding or the like.

From the perspective of the simplicity in the sealing process, adjacent wiring boards 15 in multiple wiring board 25 are preferably resin-sealed in an integrated manner as shown in the figure. However, an appropriate spacer (such as a metal mold) may be arranged in advance along the dividing lines 15a, so that the sealing resin may be formed in an intrinsically separated manner. The wiring board 15, the DSP 16, and the solid state imaging device 1 are resin-sealed, so that the sealing section 23 is formed. Accordingly, the DSP 16 and the solid state imaging device 1 are surrounded by the wiring board 15 and the sealing section 23, and hence hardly affected by the outer environment. This permits size reduction, and also improves environmental durability (such as against moisture) and mechanical strength.

FIG. 27 shows the situation of assembling of the lens retainer 18. In each wiring board 15, the lens retainer 18 (lens 17) and the solid state imaging device 1 are aligned appropriately to each other. Then, the lens retainer 18 is adhered and attached to the sealing section 23 using adhesive resin. The method of attachment (linkage) is the same as that of Embodiment 6; and hence detailed description is omitted. As a result of these processes, a plurality of optical device modules 42 (of integrated lens type) corresponding to the respective wiring boards 15 are formed on the multiple wiring board 25. In the above-mentioned example, the lens retainer 18 is adhered to the surface of the sealing section 23. However, when adjacent sealing sections 23 are formed in an intrinsically separated manner, the lens retainer 18 may be adhered to the side surface of the sealing section 23 or to the wiring board 15. After that, a plurality of the optical device modules 42 formed on the multiple wiring board 25 are divided (cut out) into individual pieces along the dividing lines 15a using a dicing machine, a router, a metal mold press, or the like. As a result, individual optical device modules 42 (FIG. 25) are formed.

Since the sealing section 23 can be formed in planar dimensions similar to those of the wiring board 15, the planar dimensions of the sealing section 23 can be formed larger in comparison with the case that the solid state imaging module component 22 is used. This allows the lens retainer 18 and the sealing section 23 to be adhered with a larger area, and hence ensures the linkage so as to improve the mechanical strength. Further, when the lens retainer 18 is adhered to the surface of the sealing section 23, a simplified shape can be used in the lens retainer 18. This simplifies the assembling of the lens retainer 18.

Further, a multiple lens retainer formed by linking a plurality of lens retainers 18 may be used in correspondence to the multiple wiring board 25. In this case, the process of aligning the lens retainer 18 (lens 17) with the solid state imaging device 1 and the process of linking the lens retainer 18 with the sealing section 23 are simplified. Alternatively, as described in Embodiments 6 and 7, the individual lens retainer 18 may be linked to the sealing section 23.

In this embodiment, the solid state imaging device in which the light-transparent cover having planar dimensions smaller than those of the solid state image pickup device is attached (adhered by the adhering section) opposite to the effective pixel region of the solid state image pickup device is built into the optical device module. This permits the size reduction (thickness reduction and weight reduction) of the optical device module. Since the solid state imaging device (solid state image pickup device) the effective pixel region of which is protected by the light-transparent cover is assembled into the optical device module, the attachment of dust is avoided to the surface of the effective pixel region of the solid state imaging device (solid state image pickup device) in the processes after the assembling of the solid state imaging device. This permits the fabrication even under a production environment of low cleanness.

This realizes an optical device module and a method of its fabrication that permit yield improvement, process simplification, and price reduction. Further, a multiple wiring board formed by linking a plurality of wiring boards is used. This permits simultaneous fabrication of a plurality of optical device modules, and hence improves further the production efficiency of the optical device module. Further, this achieves uniformity in the characteristics of the optical device modules.

In the present embodiment, in place of the use of a module component wiring board, a DSP (serving as an image processor) and a solid state imaging device (solid state image pickup device) are integrated onto a wiring board having higher strength than the module component wiring board, so that a sealing section for resin-sealing them is formed. This simplifies further the fabrication process. Further, since the wiring board performs resin sealing, an optical device module is obtained that has higher environmental durability (such as against moisture) and mechanical strength. Further, this configuration allows the lens retainer to be attached to the sealing section. This permits a simpler shape of the lens retainer, and hence simplifies the assembling of the lens retainer.

As described above in detail, according to the invention, the light-transparent cover having planar dimensions smaller than those of the solid state image pickup device is formed opposite to the effective pixel region. This permits the size reduction to a practical limit, and hence realizes a small solid state imaging device of a chip size. Further, the effective pixel region is protected by the light-transparent cover. This prevents external influences (such as moisture and dust) from affecting the surface of the effective pixel region, and hence realizes a solid state imaging device having high reliability and environmental durability.

According to the invention, the adhering section contains photosensitive adhesive. This permits the use of a photolithography technique, so as to realize simultaneous precise pattern formation of a plurality of the adhering sections. This permits the adhering section having a precise shape and aligned precisely.

According the invention, a space is formed between the effective pixel region and the light-transparent cover, so as to avoid any optical material. This prevents physical stress from acting on the effective pixel region. Further, this avoids an optical loss (reduction in the light transparency) between the light-transparent cover and the effective pixel region.

According to the invention, the adhering section seals completely the outer periphery of the space formed between the light-transparent cover and the effective pixel region. This prevents the entering of moisture and the entering and adhering of dust into (the surface of) the effective pixel region, and hence permits a reliable and environment-durable solid state imaging device. Further, this avoids the occurrence of defects in the effective pixel region caused by scratches or physical stress during the fabrication process.

According to the invention, in the semiconductor wafer on which a plurality of solid state image pickup devices are formed, a light-transparent plate, a light-transparent cover, or a light-transparent cover formed by dividing a light-transparent plate each for protecting the surface of the effective pixel region of the solid state image pickup device is formed before a plurality of the solid state image pickup devices are divided into individual pieces. This permits a small solid state imaging device, and provides a semiconductor wafer having good storage property and carriage property. Further, the effective pixel region is protected by the light-transparent plate or the light-transparent cover, in the semiconductor wafer state that a plurality of solid state image pickup devices are formed. This permits a semiconductor wafer in which the occurrence of defects in the surface of the effective pixel region is suppressed and reduced in the processes after the dividing of the solid state image pickup devices into individual pieces.

According to the invention, an optical device module is fabricated with incorporating a small solid state imaging device. This permits a small optical device module having good portability.

According to the invention, before a plurality of the solid state image pickup devices are divided into individual pieces, the light-transparent cover is adhered or formed over the effective pixel region of the solid state image pickup device so as to protect the effective pixel region. This avoids the attachment of dust and the occurrence of a scratch in the surface of the effective pixel region after the process of dividing the solid state image pickup devices into individual pieces, so as to reduce the fraction defective in the solid state imaging device.

According to the invention, adhesive formed in a pattern on the solid state image pickup device on a semiconductor wafer, or alternatively on the light-transparent plate, is used so as to adhere the light-transparent cover (light-transparent plate). This permits simultaneous pattern formation of the adhesive in a plurality of the solid state image pickup devices or in a plurality of the light-transparent covers, and hence improves the productivity. Further, in the dividing of the adhesive-patterned light-transparent plate on which the adhesive is patterned, the light-transparent plate is divided in the state that the adhesive-patterned surface is affixed to a dicing tape. This permits the formation of the light-transparent covers with reduced production of dust.

According to the invention, after the semiconductor wafer is adhered to the light-transparent plate, the light-transparent plate is divided so as to form the light-transparent cover for each solid state image pickup device. This achieves simultaneous adhesion of the light-transparent covers to a plurality of the solid state image pickup devices. That is, this simplifies the alignment of the light-transparent cover in comparison with the case that the light-transparent cover is adhered individually to each solid state image pickup device, so as to simplify the process and improve the productivity.

According to the invention, an optical device module and a method of its fabrication are provided in which the solid state imaging device (solid state image pickup device) the effective pixel region of which is protected by the light-transparent cover is built into the optical device module. In addition to size reduction (thickness reduction and weight reduction), this permits yield improvement, process simplification, and price reduction in the optical device module and in the method of its fabrication. Since the surface of the solid state imaging device (solid state image pickup device) is protected by the light-transparent cover, dust is prevented from attaching to the surface of the solid state imaging device (solid state image pickup device) in the processes after the assembling of the solid state imaging device even in a production environment of low cleanness. This avoids the necessity of high cleanness in the assembling process for the optical device module incorporating the solid state imaging device the effective pixel region of which is protected by the light-transparent cover. Thus, this avoids the necessity of special measures such as the introduction of a fabrication apparatus in which the occurrence of dust is suppressed, the improvement of a fabrication apparatus for reducing the occurrence of dust, and the addition of a process for removing the dust particles attached to the sensor surface (effective pixel region), which have been necessary in the prior art.

The invention permits production even in a production environment of low cleanness. This avoids the necessity of costly equipment investment, and achieves process reduction, production cost reduction, material cost reduction, and yield improvement. This results in an improved production efficiency in the assembling process and a reduced fabrication cost of the optical device module. Further, since the invention permits production even in a production environment of low cleanness, the factory for the assembling process of the optical device module is easily expanded. This permits easy expansion of the production.

According to the invention, a solid state imaging module component formed by integrating and resin-sealing a DSP (serving as an image processor) and a solid state imaging device (solid state image pickup device) is used, so as to realize an optical device module and a method of its fabrication which permit higher environmental durability (such as against moisture) and mechanical strength. The solid state imaging module component is wire-bonded in a predetermined manner to the solid state imaging device (solid state image pickup device) or the like, and then resin-sealed so as to be provided with external terminals connectable to the outside by soldering or the like. This avoids the necessity of precise work such as wire bonding, and hence permits easy assembling into another wiring board so as to provide an optical device module and a method of its fabrication which permit good productivity.

According to the invention, a solid state imaging module component formed by integrating and resin-sealing a DSP (serving as an image processor) and a solid state imaging device (solid state image pickup device) is used. This provides an optical device module and a method of its fabrication which permit production even in a production environment of lower cleanness in comparison with the case that the DSP (serving as an image processor) and the solid state imaging device (solid state image pickup device) are not in the integrated and resin-sealed form. Further, the solid state imaging module component comprises external terminals connectable to the outside by soldering or the like. This avoids the necessity of wire bonding, and hence permits the fabrication of the optical device module even in a factory without wire bonding equipment. Furthermore, the solid state imaging module component can be used as a ready made component. This simplifies the designing of an optical device module, and hence reduces the term of development of the optical device module.

According to the invention, a DSP (serving as an image processor) and a solid state imaging device (solid state image pickup device) are integrated onto a wiring board, so that a sealing section for resin-sealing them is formed. This provides an optical device module and a method of its fabrication which simplify further the fabrication process. Further, since the wiring board performs resin sealing, an optical device module is obtained that has higher environmental durability (such as against moisture) and mechanical strength. Further, this configuration allows the lens retainer to be attached to the sealing section. This permits a simpler shape of the lens retainer, and hence simplifies the assembling of the lens retainer.

## Claims

1. A solid state imaging device (1) comprising:
a solid state image pickup device (2) having an effective pixel region (3) in one surface thereof
a light-transparent cover (4) arranged opposite to said effective pixel region (3) and having planar dimensions smaller than those of said solid state image pickup device (2); and
an adhering section (5) for adhering said solid state image pickup device (2) and said light-transparent cover (4).

2. A solid state imaging device (1) according to Claim 1, wherein said adhering section (5) contains photosensitive adhesive.

3. A solid state imaging device (1) according to Claim 1 or 2, wherein a space is formed between said effective pixel region (3) and said light-transparent cover (4), and wherein said adhering section (5) is formed outside said effective pixel region (3) in said one surface of said solid state image pickup device (2).

4. A solid state imaging device (1) according to Claim 3, wherein said adhering section (5) seals the outer periphery of said space.

5. A semiconductor wafer (20) on which a plurality of solid state image pickup devices (2) each having an effective pixel region (3) in one surface thereof are formed, comprising:
a light-transparent plate (10) arranged opposite to said effective pixel region (3); and
an adhering section (5) for adhering said solid state image pickup device (2) and said light-transparent plate (10).

6. A semiconductor wafer (20) according to Claim 5, wherein said light-transparent plate (10) is divided so as to form light-transparent covers (4) each having planar dimensions smaller than those of said solid state image pickup device (2).

7. A semiconductor wafer (20) according to Claim 6, wherein said adhering section (5) contains photosensitive adhesive.

8. A semiconductor wafer (20) according to Claim 6, wherein a space is formed between said effective pixel region (3) and said light-transparent cover (4), and wherein said adhering section (5) is formed outside said effective pixel region (3) in said one surface of said solid state image pickup device (2).

9. A semiconductor wafer (20) according to Claim 8, wherein said adhering section (5) seals the outer periphery of said space.

10. A semiconductor wafer (20) on which a plurality of solid state image pickup devices (2) each having an effective pixel region (3) in one surface thereof are formed, comprising:
a light-transparent cover (4) arranged opposite to said effective pixel region (3); and
an adhering section (5) for adhering said solid state image pickup device (2) and said light-transparent cover (4).

11. A semiconductor wafer (20) according to Claim 10, wherein said adhering section (5) contains photosensitive adhesive.

12. A semiconductor wafer (20) according to Claim 11, wherein a space is formed between said effective pixel region (3) and said light-transparent cover (4), and wherein said adhering section (5) is formed outside said effective pixel region (3) in said one surface of said solid state image pickup device (2).

13. A semiconductor wafer (20) according to Claim 12, wherein said adhering section (5) seals the outer periphery of said space.

14. An optical device module (39, 40, 41, 42) comprising:
a lens (17);
a lens retainer (18) for retaining said lens (17); and
a solid state imaging device (1) according to any one of Claims 1-4, wherein said light-transparent cover (4) is arranged opposite to said lens (17) and inside said lens retainer (18).

15. A method of solid state imaging device (1) fabrication, comprising the steps of:
forming a plurality of solid state image pickup devices (2) each having an effective pixel region (3) in one surface thereof, onto a semiconductor wafer (20);
adhering a light-transparent cover (4) having planar dimensions smaller than those of said solid state image pickup device (2), in a manner opposite to said effective pixel region (3) onto said one surface; and
dividing a plurality of said solid state image pickup devices (2) onto each of which said light-transparent cover (4) has been adhered, into individual solid state image pickup devices (2).

16. A method of solid state imaging device (1) fabrication according to Claim 15, further comprising the step of dividing a light-transparent plate (10) so as to form said light-transparent covers (4).

17. A method of solid state imaging device (1) fabrication according to Claim 15 or 16, wherein in said step of adhering, adhesive is used that is patterned in a region outside said effective pixel region (3) in said one surface of said solid state image pickup device (2).

18. A method of solid state imaging device (1) fabrication according to Claim 16, wherein in said step of adhering, adhesive is used that is patterned on said light-transparent plate (10) in correspondence to a region outside said effective pixel region (3) in said one surface of said solid state image pickup device (2).

19. A method of solid state imaging device (1) fabrication according to Claim 18, wherein the adhesive-patterned surface of said light-transparent plate (10) is affixed onto a dicing tape, and then said light-transparent plate (10) is divided so as to form said light-transparent covers (4).

20. A method of solid state imaging device (1) fabrication according to any one of Claims 17-19, wherein said adhesive contains photosensitive adhesive.

21. A method of solid state imaging device (1) fabrication, comprising the steps of:
forming a plurality of solid state image pickup devices (2) each having an effective pixel region (3) in one surface thereof, onto a semiconductor wafer (20);
adhering a light-transparent plate (10) onto said one surface of said semiconductor wafer (20);
dividing said light-transparent plate (10) having been adhered onto said semiconductor wafer (20), so as to form light-transparent covers (4) each being opposite to said effective pixel region (3); and
dividing a plurality of said solid state image pickup devices (2) into individual solid state image pickup devices (2).

22. A method of solid state imaging device (1) fabrication according to Claim 21, wherein in said step of adhering, adhesive is used that is patterned in a region outside said effective pixel region (3) in said one surface of said solid state image pickup device (2).

23. A method of solid state imaging device (1) fabrication according to Claim 21, wherein in said step of adhering, adhesive is used that is patterned on said light-transparent plate (10) in correspondence to a region outside said effective pixel region (3) in said one surface of said solid state image pickup device (2).

24. A method of solid state imaging device (1) fabrication according to Claim 22 or 23, wherein said adhesive contains photosensitive adhesive.

25. An optical device module (39, 40, 41, 42) comprising:
a wiring board (15) on which wiring (15p) is formed;
an image processor (16) adhered to said wiring board (15) and electrically connected to said wiring (15p);
a solid state imaging device (1) in which a light-transparent cover (4) having planar dimensions smaller than those of a solid state image pickup device (2) is attached opposite to the effective pixel region (3) of said solid state image pickup device (2), and which is adhered to said image processor (16) and electrically connected to said wiring (15p); and
an optical path defining unit (18) arranged opposite to said solid state imaging device (1) and defining an optical path to said solid state imaging device (1).

26. An optical device module (39, 40, 41, 42) according to Claim 25, wherein said optical path defining unit (18) retains a lens (17) arranged opposite to said light-transparent cover (4) of said solid state imaging device (1).

27. An optical device module (41) comprising:
a solid state imaging module component (22) formed by resin-sealing: a module component wiring board (21) on which wiring (21p) is formed; an image processor (16) adhered to said module component wiring board (21) and electrically connected to said wiring (21p); and a solid state imaging device (1) in which a light-transparent cover (4) having planar dimensions smaller than those of a solid state image pickup device (2) is attached opposite to the effective pixel region (3) of said solid state image pickup device (2), and which is adhered to said image processor (16) and electrically connected to said wiring (21p); in a state that the surface of said light-transparent cover (4) is exposed; and
an optical path defining unit (18) arranged opposite to said solid state imaging device (1) and defining an optical path to said solid state imaging device (1).

28. An optical device module (41) according to Claim 27, wherein an external terminal (21b) connected to said wiring (21p) is formed on the surface of said module component wiring board (21) reverse to the surface to which said image processor (16) is adhered.

29. An optical device module (41) according to Claim 28, wherein said external terminal (21b) has a protruding shape.

30. An optical device module (41) according to Claim 28 or 29, wherein said optical device module (41) further comprises a wiring board (15) on which wiring (15p) is formed, and wherein said external terminal (21b) of said module component wiring board (21) is connected to said wiring (15p) of said wiring board (15).

31. An optical device module (41) according to any one of Claims 27-30, wherein said optical path defining unit (18) retains a lens (17) arranged opposite to said light-transparent cover (4) of said solid state imaging device (1).

32. An optical device module (42) comprising:
a wiring board (15) on which wiring (15p) is formed;
an image processor (16) adhered to said wiring board (15) and electrically connected to said wiring (15p);
a solid state imaging device (1) in which a light-transparent cover (4) having planar dimensions smaller than those of a solid state image pickup device (2) is attached opposite to the effective pixel region (3) of said solid state image pickup device (2), and which is adhered to said image processor (16) and electrically connected to said wiring (15p);
a sealing section (23) for resin-sealing said wiring board (15), said image processor (16), and said solid state imaging device (1) in a state that the surface of said light-transparent cover (4) is exposed; and
an optical path defining unit (18) arranged opposite to said solid state imaging device (1) and defining an optical path to said solid state imaging device (1).

33. An optical device module (42) according to Claim 32, wherein said optical path defining unit (18) retains a lens (17) arranged opposite to said light-transparent cover (4) of said solid state imaging device (1).

34. A method of optical device module (39, 40, 42) fabrication comprising the steps of
adhering an image processor (16) to a wiring board (15) on which wiring (15p) is formed, and then connecting the connection terminals of said image processor (16) to said wiring (15p);
adhering a solid state imaging device (1) in which a light-transparent cover (4) having planar dimensions smaller than those of a solid state image pickup device (2) is attached opposite to the effective pixel region (3) of said solid state image pickup device (2), to said image processor (16), and then connecting the connection terminals of said solid state imaging device (1) to said wiring (15p); and
positioning said solid state imaging device (1) and an optical path defining unit (18) for defining an optical path to said solid state imaging device (1).

35. A method of optical device module (40, 42) fabrication according to Claim 34, wherein a plurality of optical device modules are formed simultaneously on a multiple wiring board (25) formed by linking a plurality of said wiring boards (15), and wherein said multiple wiring board (25) is then divided so that a plurality of said optical device modules are divided into individual optical device modules.

36. A method of optical device module (41) fabrication comprising the steps of
adhering an image processor (16) to a module component wiring board (21) on which wiring (21p) is formed, and then connecting the connection terminals of said image processor (16) to said wiring (21p);
adhering a solid state imaging device (1) in which a light-transparent cover (4) having planar dimensions smaller than those of a solid state image pickup device (2) is attached opposite to the effective pixel region (3) of said solid state image pickup device (2), to said image processor (16), and then connecting the connection terminals of said solid state imaging device (1) to said wiring (21p);
resin-sealing said module component wiring board (21), said image processor (16), and said solid state imaging device (1) in a state that the surface of said light-transparent cover (4) is exposed, and thereby forming a solid state imaging module component (22); and
positioning said solid state imaging device (1) and an optical path defining unit (18) for defining an optical path to said solid state imaging device (1).

37. A method of optical device module (41) fabrication according to Claim 36, wherein an external terminal (21b) is formed on the surface of said module component wiring board (21) reverse to the surface to which said image processor (16) is adhered, and wherein said method further comprises the step of connecting said external terminal (21b) to said wiring (15p) formed on said wiring board (15).

38. A method of optical device module (41) fabrication according to Claim 37, wherein said external terminal (21b) has a protruding shape.

39. A method of optical device module (41) fabrication according to any one of Claims 36-38, wherein a plurality of solid state imaging module components (22) are formed simultaneously on a multiple module component wiring board (26) formed by linking a plurality of said module component wiring boards (21), and wherein said multiple module component wiring board (26) is then divided so that a plurality of said solid state imaging module components (22) are divided into individual solid state imaging module components (22).

40. A method of optical device module (41) fabrication according to any one of Claims 37-39, wherein a plurality of optical device modules (41) are formed simultaneously on a multiple wiring board (25) formed by linking a plurality of said wiring boards (15), and wherein said multiple wiring board (25) is then divided so that a plurality of said optical device modules (41) are divided into individual optical device modules (41).

41. A method of optical device module (42) fabrication comprising the steps of:
adhering an image processor (16) to a wiring board (15) on which wiring (15p) is formed, and then connecting the connection terminals of said image processor (16) to said wiring (15p);
adhering a solid state imaging device (1) in which a light-transparent cover (4) having planar dimensions smaller than those of a solid state image pickup device (2) is attached opposite to the effective pixel region (3) of said solid state image pickup device (2), to said image processor (16), and then connecting the connection terminals of said solid state imaging device (1) to said wiring (15p);
resin-sealing said wiring board (15), said image processor (16), and said solid state imaging device (1) in a state that the surface of said light-transparent cover (4) is exposed, and thereby forming a sealing section (23); and
positioning said solid state imaging device (1) and an optical path defining unit (18) for defining an optical path to said solid state imaging device (1).

42. A method of optical device module (42) fabrication according to Claim 41, wherein a plurality of optical device modules (42) are formed simultaneously on a multiple wiring board (25) formed by linking a plurality of said wiring boards (15), and wherein said multiple wiring board (25) is then divided so that a plurality of said optical device modules (42) are divided into individual optical device modules (42).
